# EUROPEAN PATENT APPLICATION

(11) **EP 3 511 611 A1**
(43) Date of publication of application: **17.07.2019**
(21) Application number: 17848698.1
(22) Date of filing: 04.09.2017
(51) Int. Cl.: F21V 1/17

(54) **WAVELENGTH CONVERSION SHEET, LAMINATE, LIGHT-EMITTING DEVICE, AND METHOD FOR PRODUCING WAVELENGTH CONVERSION SHEET**

(30) Priority: 07.09.2016 JP 2016175093
(71) Applicant: Sumitomo Chemical Co., Ltd., Tokyo 104-8260 (JP)
(72) Inventor: MASUI, Kentaro, Osaka-shi Osaka 554-8558 (JP); DOI, Atsunori, Tsukuba-shi Ibaraki 300-3294 (JP)
(74) Representative: Winter, Brandl, Fürniss, Hübner, Röss, Kaiser, Polte - Partnerschaft mbB
(86) International application number: PCT/JP2017/031730
(87) International publication number: WO 2018/047758

(57) **Abstract**

Provided is a wavelength conversion sheet excellent in heat resistance, a laminate and light-emitting device including the wavelength conversion sheet, and a method for producing the wavelength conversion sheet.

A wavelength conversion sheet containing a condensed silicone resin cured product, and a wavelength conversion material, the wavelength conversion sheet having
a storage modulus at 25°C of 2 GPa or more and 10 GPa or less, and
a storage modulus at 150°C of 0.1 GPa or more and 5 GPa or less.

The wavelength conversion sheet, wherein the content of the condensed silicone resin cured product is 5% by mass or more and 80% by mass or less, to the total content of the condensed silicone resin cured product and the wavelength conversion material.

## Description

### TECHNICAL FIELD

The present invention relates to a wavelength conversion sheet, a laminate and a light-emitting device, and a method for producing a wavelength conversion sheet.

### BACKGROUND ART

A semiconductor laser (LD, Laser Diode) can maintain high conversion efficiency even in a high current density region. Further, it is also possible to downsize a device by separating a light emitting portion and an excitation portion of the semiconductor laser. Therefore, it is expected to use a semiconductor laser for a lighting device.

An emission spectrum of a semiconductor laser depends on a semiconductor material which is a material for forming the semiconductor laser. Currently, a method of emitting all three colors of RGB by a semiconductor laser (the former method), and a method for obtaining white light by arranging an LD element and a wavelength conversion material, irradiating the wavelength conversion material with light emitted from the LD element and converting an emission wavelength (the latter method) are adopted. Since the latter method is suitable for downsizing of the device, development to applications such as projectors has been studied.

The emission spectrum of the light emitting diode (LED) also depends on a semiconductor material which is the material for forming the light emitting diode. A light-emitting device in which a sheet containing a phosphor as a wavelength conversion material (hereinafter referred to as "phosphor sheet") is arranged on a light emitting surface of an LED element is known (see, for example, Patent Document 1).

### PRIOR ART DOCUMENT

### PATENT DOCUMENT

Patent Document 1: JP-A-2013-001792

### SUMMARY OF THE INVENTION

### PROBLEMS TO BE SOLVED BY THE INVENTION

However, the phosphor sheet described in Patent Document 1 did not have sufficient heat resistance. Specifically, when the phosphor sheet described in Patent Document 1 was applied to a phosphor sheet of a semiconductor light-emitting device using a high output LD element, a resin contained in the phosphor sheet deteriorated due to heat generation accompanying high energy density light irradiation, and cracks, coloration, wrinkles or the like occurred in the phosphor sheet in some cases. Therefore, a wavelength conversion sheet excellent in heat resistance has been required.

The present invention has been made in view of such circumstances, and it is an object of the present invention to provide a wavelength conversion sheet excellent in heat resistance, a laminate and light-emitting device including the wavelength conversion sheet, and a method for producing the wavelength conversion sheet.

### MEANS FOR SOLVING THE PROBLEMS

In order to solve the above problem, the present invention provides the following [1] to [11].
[1] A wavelength conversion sheet containing a condensed silicone resin cured product, and a wavelength conversion material, the wavelength conversion sheet having a storage modulus at 25°C of 2 GPa or more and 10 GPa or less and a storage modulus at 150°C of 0.1 GPa or more and 5 GPa or less.
[2] The wavelength conversion sheet according to [1], wherein the content of the condensed silicone resin cured product is 5% by mass or more and 80% by mass or less to the total content of the condensed silicone resin cured product and the wavelength conversion material.
[3] The wavelength conversion sheet according to [1] or [2], wherein the thickness is 10 µm or more and 1 mm or less.
[4] The wavelength conversion sheet according to any of [1] to [3], wherein the condensed silicone resin cured product contains a structural unit represented by the following formula (A3), 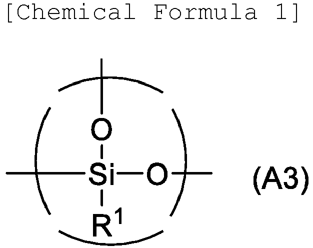 wherein R¹ represents an alkyl group having 1 to 10 carbon atoms or an aryl group having 6 to 10 carbon atoms.
[5] The wavelength conversion sheet according to [4], wherein the condensed silicone resin cured product may further contain one or more structural units selected from the group consisting of a structural unit represented by the following formula (A1), a structural unit represented by the following formula (A1') and a structural unit represented by the following formula (A2), and
   the total content of the structural unit represented by the formula (A3), the structural unit represented by the following formula (A1), the structural unit represented by the following formula (A1') and the structural unit represented by the following formula (A2) contained in the condensed silicone resin cured product is 50% by mole or more to the total content of all structural units contained in the condensed silicone resin cured product. 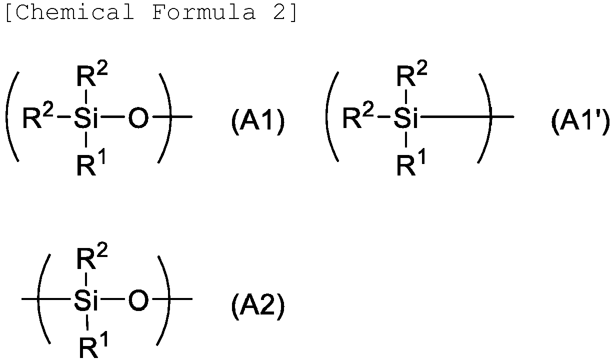 In the formulas (A1), (A1') and (A2),
   R¹ represents an alkyl group having 1 to 10 carbon atoms or an aryl group having 6 to 10 carbon atoms;
   R² represents an alkoxy group having 1 to 4 carbon atoms or a hydroxyl group; and
   a plurality of R¹s and R²s each may be the same or different.
[6] The wavelength conversion sheet according to [4] or [5], wherein the content of the structural unit represented by the formula (A3) contained in the condensed silicone resin cured product is 50% by mole or more, to the total content of all structural units contained in the condensed silicone resin cured product.
[7] The wavelength conversion sheet according to [5] or [6], wherein the R¹s are a methyl group, and the R²s are an alkoxy group having 1 to 3 carbon atoms or a hydroxyl group.
[8] The wavelength conversion sheet according to any of [1] to [7], wherein the Shore D hardness is 50 or more.
[9] A laminate including a wavelength conversion sheet as defined in any of [1] to [8]; and
   a substrate provided on one surface of the wavelength conversion sheet.
[10] A light-emitting device containing the wavelength conversion sheet as defined in any of [1] to [8] or the laminate as defined in [9].
[11] A method for producing the wavelength conversion sheet as defined in any of [4] to [8], including:
   a preparation step of preparing a wavelength conversion material-containing silicone resin composition containing a condensed silicone resin, a wavelength conversion material, and a solvent;
   a molding step of molding a wavelength conversion material-containing silicone resin composition into a sheet to obtain a molded body;
   a first heating step of curing the molded body by allowing it to stand in an atmosphere heated from room temperature to 120°C so as to satisfy a requirement of 0.60 ≤ E/D ≤ 0.97; and
   a second heating step of curing the molded body after the first heating step by allowing it to stand in an atmosphere heated from 120°C to 150°C so as to satisfy a requirement of 1.01 ≤ C/B ≤ 1.30,
      wherein,
   D represents a mass of the molded body before the first heating step;
   E represents a mass of the molded body after the first heating step;
   B represents a content of the structural unit represented by the formula (A3) to the total content of all structural units contained in the molded body after the first heating step; and
   C represents a content of the structural unit represented by the formula (A3) to the total content of all structural units contained in the molded body after the second heating step.

### EFFECT OF THE INVENTION

According to the present invention, it is possible to provide a wavelength conversion sheet excellent in heat resistance, a laminate and light-emitting device including the wavelength conversion sheet, and a method for producing a wavelength conversion sheet.

### BRIEF DESCRIPTION OF THE DRAWINGS

Fig. 1 is a schematic diagram showing a light-emitting device of the present embodiment.
Fig. 2 is a schematic diagram showing a light-emitting device of the present embodiment.

### MODE FOR CARRYING OUT THE INVENTION

Hereinafter, embodiments of the present invention will be described.

A structural unit contained in a condensed silicone resin cured product is preferably contained in the condensed silicone resin cured product as a repeating unit.

### <Wavelength Conversion Sheet>

The wavelength conversion sheet of the present embodiment contains a condensed silicone resin cured product and a wavelength conversion material. The condensed silicone resin used for producing the wavelength conversion sheet of the present embodiment is a resin to be mixed with a wavelength conversion material and can be formed into a sheet. In addition, the condensed silicone resin cured product contained in the wavelength conversion sheet of the present embodiment is a resin excellent in heat resistance because less wrinkles, cracks and the like occur even when exposed to high temperature.

### [Condensed Silicone Resin Cured Product]

A condensed silicone resin is used as a raw material for the condensed silicone resin cured product contained in the wavelength conversion sheet of the present embodiment. That is, the term "condensed silicone resin cured product" refers to a cured product obtained by curing a condensed silicone resin by condensation reaction, and does not have fluidity.

The condensed silicone resin refers to a resin polycondensed by dealcoholization reaction or dehydration reaction of a hydroxyl group bonded to a silicon atom and an alkoxy group or hydroxyl group bonded to another silicon atom.

The specific gravity of the condensed silicone resin cured product contained in the wavelength conversion sheet of the present embodiment is preferably 1.20 to 1.35.

The condensed silicone resin cured product contained in the wavelength conversion sheet of the present embodiment preferably contains a structural unit represented by the following formula (A3). Further, the condensed silicone resin cured product contained in the wavelength conversion sheet of the present embodiment preferably further contains one or more structural units selected from the group consisting of a structural unit represented by the following formula (A1), a structural unit represented by the following formula (A1'), and a structural unit represented by the following formula (A2). 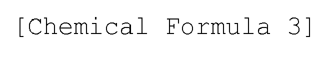 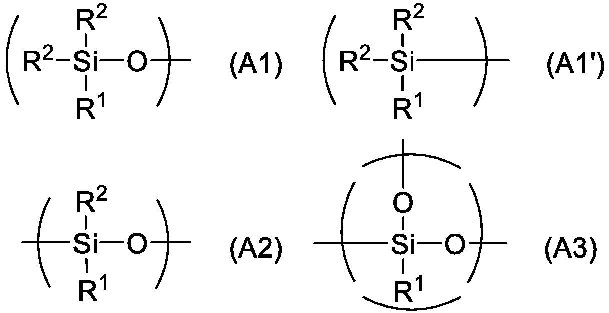 In the formulas (A1), (A1'), (A2) and (A3),
R¹ represents an alkyl group having 1 to 10 carbon atoms or an aryl group having 6 to 10 carbon atoms;
R² represents an alkoxy group having 1 to 4 carbon atoms or a hydroxyl group; and
a plurality of R¹s and R²s each may be the same or different.

The condensed silicone resin cured product contained in the wavelength conversion sheet of the present embodiment preferably contains all of the structural unit represented by formula (A3), the structural unit represented by formula (A1), the structure represented by formula (A1'), and the structural unit represented by the formula (A2).

In the present specification, a structural unit containing a silicon atom bonded to three oxygen atoms is referred to as "T unit".

Also, a structural unit containing a silicon atom in which all the three oxygen atoms are bonded to other silicon atoms is referred to as "T3 unit".

Further, a structural unit containing a silicon atom in which two oxygen atoms among the three oxygen atoms are bonded to other silicon atoms is referred to as "T2 unit".

Moreover, a structural unit containing a silicon atom in which one oxygen atom among the three oxygen atoms is bonded to another silicon atom is referred to as "T1 unit".

That is, the "T unit" means "T1 unit", "T2 unit" and "T3 unit".

In the present specification, a structural unit containing a silicon atom bonded to two oxygen atoms is referred to as "D unit". A structural unit containing a silicon atom bonded to one oxygen atom is referred to as "M unit". A structural unit containing a silicon atom bonded to four oxygen atoms is referred to as "Q unit".

The structural unit represented by the formula (A3) contains three oxygen atoms bonded to other silicon atoms and a silicon atom bonded to R¹. Since R¹ is an alkyl group having 1 to 10 carbon atoms or an aryl group having 6 to 10 carbon atoms, the structural unit represented by the formula (A3) is a T3 unit.

The structural unit represented by the formula (A2) contains two oxygen atoms bonded to other silicon atoms, and a silicon atom bonded to R¹ and R². Since R² is an alkoxy group having 1 to 4 carbon atoms or a hydroxyl group, the structural unit represented by the formula (A2) is a T2 unit.

The structural unit represented by the formula (A1) contains one oxygen atom bonded to another silicon atom, and a silicon atom bonded to R¹ and two R²s. Since R¹ is an alkyl group having 1 to 10 carbon atoms or an aryl group having 6 to 10 carbon atoms and R² is an alkoxy group having 1 to 4 carbon atoms or a hydroxyl group, the structural unit represented by the formula (A1) is a T1 unit.

The structural unit represented by the formula (A1') contains a silicon atom bonded to R¹ and two R²s, and the silicon atom is bonded to an oxygen atom bonded to a silicon atom in another structural unit. Since R¹ is an alkyl group having 1 to 10 carbon atoms or an aryl group having 6 to 10 carbon atoms and R² is an alkoxy group having 1 to 4 carbon atoms or a hydroxyl group, the structural unit represented by the formula (A1') is a T1 unit.

The structural unit represented by the formula (A1) and the structural unit represented by the formula (A1') constitute an end of an organopolysiloxane chain contained in the condensed silicone resin cured product. Further, the structural unit represented by the formula (A3) constitutes a branched chain structure of the organopolysiloxane chain contained in the condensed silicone resin cured product. That is, the structural unit represented by the formula (A3) forms a part of a network structure and a ring structure of the condensed silicone resin cured product.

In the present specification, the silicon atom contained in the T3 unit is referred to as "T3 silicon atom". Also, the silicon atom contained in the T2 unit is referred to as "T2 silicon atom". Moreover, the silicon atom contained in the T1 unit is referred to as "T1 silicon atom".

In the condensed silicone resin cured product contained in the wavelength conversion sheet of the present embodiment, the total content of the structural unit represented by the formula (A3), the structural unit represented by the formula (A1), the structural unit represented by the formula (A1') and the structural unit represented by the formula (A2) is preferably 50% by mole or more, more preferably 60% by mole or more, further preferably 70% by mole or more, particularly preferably 80% by mole or more, and more particularly preferably 90% by mole or more, to the total content of all structural units contained in the condensed silicone resin cured product.

In other words, in the condensed silicone resin cured product contained in the wavelength conversion sheet of the present embodiment, the total content of the T1 unit, T2 unit and T3 unit is preferably 50% by mole or more, more preferably 60% by mole or more, further preferably 70% by mole or more, particularly preferably 80% by mole or more, and more particularly preferably 90% by mole or more, to the total content of all structural units contained in the condensed silicone resin cured product.

In more other words, in the condensed silicone resin cured product contained in the wavelength conversion sheet of the present embodiment, the total content of T1 silicon atoms, T2 silicon atoms and T3 silicon atoms is preferably 50% by mole or more, more preferably 60% by mole or more, further preferably 70% by mole or more, particularly preferably 80% by mole or more, and more particularly preferably 90% by mole or more, to the total content of all silicon atoms contained in the condensed silicone resin cured product.

In the condensed silicone resin cured product contained in the wavelength conversion sheet of the present embodiment, the content of the structural unit represented by the formula (A3) is preferably 50% by mole or more, more preferably 55% by mole or more, further preferably 60% by mole or more, particularly preferably 65% by mole or more, and more particularly preferably 70% by mole or more, to the total content of all structural units contained in the condensed silicone resin cured product.

In other words, in the condensed silicone resin cured product contained in the wavelength conversion sheet of the present embodiment, the content of the T3 unit is preferably 50% by mole or more, more preferably 55% by mole or more, further preferably 60% by mole or more, particularly preferably 65% by mole or more, and more particularly preferably 70% by mole or more, to the total content of all structural units contained in the condensed silicone resin cured product.

In more other words, in the condensed silicone resin cured product contained in the wavelength conversion sheet of the present embodiment, the content of T3 silicon atoms is preferably 50% by mole or more, more preferably 55% by mole or more, further preferably 60% by mole or more, particularly preferably 65% by mole or more, and more particularly preferably 70% by mole or more, to the total content of all silicon atoms contained in the condensed silicone resin cured product.

When the content of the structural unit represented by the formula (A3) in the condensed silicone resin cured product contained in the wavelength conversion sheet of the present embodiment is within this range, the storage modulus at room temperature (25°C) and the storage modulus at high temperature (150°C) of the obtained wavelength conversion sheet can be controlled within a desired range.

In the condensed silicone resin cured product contained in the wavelength conversion sheet of the present embodiment, the content of the D unit is preferably 30% by mole or less, more preferably 20% by mole or less, further preferably 10% by mole or less, particularly preferably 5% by mole or less, and more particularly preferably 4% by mole or less, to the total content of all structural units contained in the condensed silicone resin cured product.

The content of the T3 silicon atoms contained in the condensed silicone resin cured product can be obtained by dividing an area of a signal assigned as the T3 silicon atom by a total area of signals of all silicon atoms determined in the solid state ²⁹Si-NMR measurement. The content of silicon atoms (T1 silicon atoms and T2 silicon atoms) other than T3 silicon atoms can also be determined in the same manner.

The alkyl group having 1 to 10 carbon atoms represented by R¹ may be a linear alkyl group, a branched chain alkyl group, or an alkyl group having a cyclic structure. Among them, a linear or branched alkyl group is preferable, a linear alkyl group is more preferable, and a methyl group is further preferable.

In the alkyl group having 1 to 10 carbon atoms represented by R¹, one or more hydrogen atoms constituting the alkyl group may be substituted with other functional groups. Examples of the substituent of the alkyl group include aryl groups having 6 to 10 carbon atoms such as a phenyl group and naphthyl group, and a phenyl group is preferable.

Examples of the alkyl group having 1 to 10 carbon atoms represented by R¹ include unsubstituted alkyl groups such as a methyl group, ethyl group, n-propyl group, isopropyl group, n-butyl group, isobutyl group, tert-butyl group, n-pentyl group, neopentyl group, hexyl group, octyl group, nonyl group and decyl group, and aralkyl groups such as a phenylmethyl group, phenylethyl group, and phenylpropyl group. Among them, a methyl group, ethyl group, n-propyl group, isopropyl group or n-butyl group is preferable, a methyl group, ethyl group or isopropyl group is more preferable, and a methyl group is further preferable.

In the aryl group having 6 to 10 carbon atoms represented by R¹, one or more hydrogen atoms constituting the aryl group may be substituted with other functional group. Examples of the substituent of the aryl group include alkyl groups having 1 to 10 carbon atoms such as a methyl group, ethyl group, propyl group, and butyl group.

Examples of the aryl group having 6 to 10 carbon atoms represented by R¹ include unsubstituted aryl groups such as a phenyl group and naphthyl group, and alkylaryl groups such as a methylphenyl group, ethylphenyl group and propylphenyl group. Among them, a phenyl group is preferable.

In the structural unit represented by the formula (A1), the structural unit represented by the formula (A1'), the structural unit represented by the formula (A2) and the structural unit represented by the formula (A3), R¹s are preferably an alkyl group, and from the viewpoint of heat resistance, it is preferably a methyl group.

The alkoxy group having 1 to 4 carbon atoms represented by R² may be a linear alkoxy group, a branched chain alkoxy group, or an alkoxy group having a cyclic structure. Among them, a linear or branched alkoxy group is preferable, and a linear alkoxy group is more preferable.

Examples of the alkoxy group having 1 to 4 carbon atoms represented by R² include a methoxy group, ethoxy group, n-propoxy group, isopropoxy group, n-butoxy group, isobutoxy group and tert-butoxy group, and from the viewpoint of achieving stability and curability of the silicone resin composition of the present embodiment in a well-balanced manner, a methoxy group, ethoxy group or isopropoxy group is preferable .

In the structural unit represented by the formula (A1), the structural unit represented by the formula (A1'), the structural unit represented by the formula (A2), and the structural unit represented by the formula (A3), R² is preferably a methoxy group or hydroxyl group.

In the condensed silicone resin cured product contained in the wavelength conversion sheet of the present embodiment, it is preferable that, in a repeating unit represented by the formula (A1), the formula (A1'), the formula (A2) and the formula (A3), R¹s are a methyl group and R²s are each independently an alkoxy group having 1 to 3 carbon atoms or a hydroxyl group.

Here, the condensed silicone resin cured product contained in the wavelength conversion sheet of the present embodiment may further contain a structural unit represented by the following formula (C1), formula (C1'), formula (C2), formula (C3) or formula (C4). 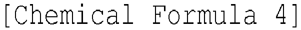 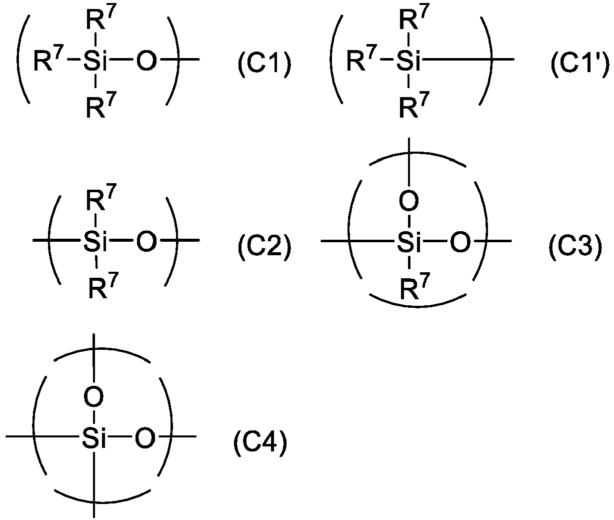 In the formula (C1), formula (C1'), formula (C2), formula (C3) and formula (C4), R⁷ represents an alkoxy group having 1 to 4 carbon atoms or a hydroxyl group, and a plurality of R⁷s each may be the same or different.

As described above, in the present specification, a structural unit containing a silicon atom bonded to four oxygen atoms is referred to as "Q unit".

Also, a structural unit containing a silicon atom in which one oxygen atom among the four oxygen atoms is bonded to another silicon atom is referred to as "Q1 unit". The structural unit represented by the formula (C1) and the structural unit represented by the formula (C1') are "Q1 units".

Moreover, a structural unit containing a silicon atom in which two oxygen atoms among the four oxygen atoms are bonded to other silicon atoms is referred to as "Q2 unit". The structural unit represented by the formula (C2) is "Q2 unit".

Further, a structural unit containing a silicon atom in which three oxygen atoms among the four oxygen atoms are bonded to other silicon atoms is referred to as "Q3 unit". The structural unit represented by the formula (C3) is "Q3 unit".

Furthermore, a structural unit containing a silicon atom in which all the four oxygen atoms are bonded to other silicon atoms is referred to as "Q4 unit". The structural unit represented by the formula (C4) is "Q4 unit".

That is, the Q unit means Q1 unit, Q2 unit, Q3 unit, and Q4 unit.

In the wavelength conversion sheet of the present embodiment, the content of the condensed silicone resin cured product is preferably 5% by mass or more and 80% by mass or less, more preferably 10% by mass or more and 70% by mass or less, further preferably 15% by mass or more and 60% by mass or less, and particularly preferably 20% by mass or more and 50% by mass or less, to the total content of the condensed silicone resin cured product and the wavelength conversion material.

In the wavelength conversion sheet of the present embodiment, when the content of the condensed silicone resin cured product is within this range, the conversion efficiency of the wavelength conversion sheet can be increased, the storage modulus at room temperature (25°C) and the storage modulus at high temperature (150°C) of the wavelength conversion sheet can be controlled within a desired range.

The content of the condensed silicone resin cured product in the wavelength conversion sheet of the present embodiment can be calculated by a value calculated from charged amounts of the condensed silicone resin, the wavelength conversion material and other raw materials, or element analysis of the wavelength conversion sheet.

### [Wavelength Conversion Material]

Examples of the wavelength conversion material contained in the wavelength conversion sheet of the present embodiment include a phosphor and a quantum dot. Examples of the phosphor include red phosphors emitting fluorescence in the wavelength range of 570 nm to 700 nm, green phosphors emitting fluorescence in the range of 490 nm to 570 nm, and blue phosphors emitting fluorescence in the range of 420 to 480 nm. Only one type of phosphor may be used alone, or two or more types thereof may be used in combination.

### <<Red Phosphor>>

Examples of the red phosphor include europium-activated alkaline earth silicon nitride phosphors expressed by (Mg,Ca,Sr,Ba)₂Si₅N₈:Eu, which are composed of broken particles having red broken surfaces, and europium-activated rare-earth oxychalcogenide phosphors expressed by (Y,La,Gd,Lu)₂O₂S:Eu, which are composed of grown particles having a nearly spherical shape as the regular crystal growth shape.

Examples of other red phosphor include phosphors containing an oxynitride and/or oxysulfide containing at least one element selected from the group consisting of Ti, Zr, Hf, Nb, Ta, W and Mo and containing an oxynitride having an alpha-sialon structure in which part or all of Al elements are substituted with Ga elements.

Other examples of the red phosphor include Eu-activated oxysulfide phosphors such as (La,Y)₂O₂S:Eu; Eu-activated oxide phosphors such as Y(V,P)O₄:Eu and Y₂O₃:Eu; Eu,Mn-activated silicate phosphors such as (Ba,Sr,Ca,Mg)₂SiO₄:Eu,Mn and (Ba,Mg)₂SiO₄:Eu,Mn; Eu-activated sulfide phosphors such as (Ca,Sr)S:Eu; Eu-activated aluminate phosphors such as YAlO₃:Eu; Eu-activated silicate phosphors such as LiY₉(SiO₄)₆O₂:Eu, Ca₂Y₈(SiO₄)₆O₂:Eu, (Sr,Ba,Ca)₃SiO₅:Eu and Sr₂BaSiO₅:Eu; Ce-activated aluminate phosphors such as (Y,Gd)₃Al₅O₁₂:Ce and (Tb,Gd)₃Al₅O₁₂:Ce; Eu-activated nitride phosphors such as (Ca,Sr,Ba)₂Si₅N₈:Eu, (Mg,Ca,Sr,Ba)SiN₂:Eu and (Mg,Ca,Sr,Ba)AlSiN₃:Eu; Ce-activated nitride phosphors such as (Mg,Ca,Sr,Ba)AlSiN₃:Ce; Eu,Mn-activated halophosphate phosphors such as (Sr,Ca,Ba,Mg)₁₀(PO₄)₆Cl₂:Eu,Mn; Eu,Mn-activated silicate salt phosphors such as (Ba₃Mg)Si₂O₈:Eu,Mn and (Ba,Sr,Ca,Mg)₃(Zn,Mg)Si₂O₈:Eu,Mn; Mn-activated germanate phosphors such as 3.5MgO · 0.5MgF₂ · GeO₂:Mn; Eu-activated oxynitride phosphors such as Eu-activated α sialon; Eu,Bi-activated oxide phosphors such as (Gd,Y,Lu,La)₂O₃:Eu,Bi; Eu,Bi-activated oxysulfide phosphors such as (Gd,Y,Lu,La)₂O₂S:Eu,Bi; Eu,Bi-activated vanadate phosphors such as (Gd,Y,Lu,La)VO₄:Eu,Bi; Eu,Ce-activated sulfide phosphors such as SrY₂S₄:Eu,Ce; Ce-activated sulfide phosphors such as CaLa₂S₄:Ce; Eu,Mn-activated phosphate phosphors such as (Ba,Sr,Ca)MgP₂O₇:Eu,Mn and (Sr,Ca,Ba,Mg,Zn)₂P₂O₇:Eu,Mn; Eu,Mo-activated tungstate phosphors such as (Y,Lu)₂WO₆:Eu,Mo; Eu, Ce-activated nitride phosphors such as (Ba,Sr,Ca)ₓSi_{y}N_{zK}:Eu,Ce (wherein x, y, and z are integers of 1 or more); Eu,Mn-activated halophosphate phosphors such as (Ca,Sr,Ba,Mg)₁₀(PO₄)₆(F,Cl,Br,OH):Eu,Mn; and Ce-activated silicate phosphors such as ((Y,Lu,Gd,Tb)₁₋ₓScₓCe_{y})₂(Ca,Mg)₁₋ᵣ(Mg,Zn)₂₊ᵣSi_{z-q}GeqO_{12+δ}.

Other examples of the red phosphor include red organic phosphors composed of a rare earth element ion complex containing an anion such as β-diketonate, β-diketone, aromatic carboxylic acid or Bronsted acid, as a ligand, perylene pigments (for example, dibenzo{[f,f']-4,4',7,7'-tetraphenyl}diindeno[1,2,3-cd:1',2',3'-lm]perylene), anthraquinone pigments, lake pigments, azo pigments, quinacridone pigments, anthracene pigments, isoindoline pigments, isoindolinone pigments, phthalocyanine pigments, triphenylmethane basic dyes, indanthrone pigments, indophenol pigments, cyanine pigments, and dioxazine pigments.

Among the red phosphors, a red phosphor having a peak wavelength of fluorescence emission of 580 nm or more and preferably 590 nm or more, and a peak wavelength of fluorescence emission of 620 nm or less and preferably 610 nm or less is suitably used as an orange phosphor. Examples of such orange phosphor include (Sr,Ba)₃SiO₅:Eu, (Sr,Mg)₃PO₄):Sn²⁺, and SrCaAlSiN₃:Eu.

### <<Yellow Phosphor>>

Examples of the yellow phosphor include oxide-based, nitride-based, oxynitride-based, sulfide-based and oxysulfide-based phosphors. Specific examples include garnet-based phosphors having a garnet structure represented by RE₃M₅O₁₂:Ce (wherein RE represents at least one element selected from the group consisting of Y, Tb, Gd, Lu and Sm, and M represents at least one element selected from the group consisting of Al, Ga and Sc), M²₃M³₂M⁴₃O₁₂:Ce (wherein M² represents a divalent metal element, M³ represents a trivalent metal element, and M⁴ represents a tetravalent metal element) or the like; orthosilicate-based phosphors represented by AE₂M⁵O₄:Eu (wherein AE represents at least one element selected from the group consisting of Ba, Sr, Ca, Mg and Zn, and M⁵ represents at least one element selected from the group consisting of Si and Ge) or the like; oxynitride-based phosphors where a part of oxygen atoms as a constituent element of these phosphors is substituted with a nitrogen atom; and phosphors activated by Ce such as nitride-based phosphors having a CaAlSiN₃ structure such as AEAlSiN₃:Ce (wherein AE represents at least one element selected from the group consisting of Ba, Sr, Ca, Mg and Zn).

Examples of other yellow phosphors include phosphors activated by Eu such as sulfide-based phosphors such as CaGa₂S₄:Eu(Ca,Sr)Ga₂S₄:Eu and (Ca, Sr) (Ga,Al)₂S₄:Eu; and oxynitride-based phosphors having a SiAlON structure such as Caₓ(Si,Al)₁₂(O,N)₁₆:Eu.

### <<Green Phosphor>>

Examples of the green phosphor include europium-activated alkaline earth silicon oxynitride-based phosphors represented by (Mg,Ca,Sr,Ba)Si₂O₂N₂:Eu, which are composed of broken particles having broken surfaces, and europium-activated alkaline earth silicate-based phosphors represented by (Ba,Ca,Sr,Mg)₂SiO₄:Eu, which are composed of broken particles having broken surfaces.

Other examples of the green phosphor include Eu-activated aluminate phosphors such as Sr₄Al₁₄O₂₅:Eu and (Ba,Sr,Ca)Al₂O₄:Eu; Eu-activated silicate salt phosphors such as (Sr,Ba)Al₂Si₂O₈:Eu, (Ba,Mg)₂SiO₄:Eu, (Ba,Sr,Ca,Mg)₂SiO₄:Eu and (Ba,Sr,Ca)₂(Mg,Zn)Si₂O₇:Eu; Ce,Tb-activated silicate phosphors such as Y₂SiO₅:Ce,Tb; Eu-activated borate phosphate phosphors such as Sr₂P₂O₇-Sr₂B₂O₅:Eu; Eu-activated halosilicate phosphors such as Sr₂Si₃O₈-2SrCl₂:Eu; Mn-activated silicate phosphors such as Zn₂SiO₄:Mn; Tb-activated aluminate phosphors such as CeMgAl₁₁O₁₉:Tb and Y₃Al₅O₁₂:Tb; Tb-activated silicate phosphors such as Ca₂Y₈(SiO₄)₆O₂:Tb and La₃Ga₅SiO₁₄:Tb; Eu,Tb,Sm-activated thiogallate phosphors such as (Sr,Ba,Ca)Ga₂S₄:Eu,Tb,Sm; Ce-activated aluminate phosphors such as Y₃(Al,Ga)₅O₁₂:Ce and (Y,Ga,Tb,La,Sm,Pr,Lu)₃(Al,Ga)₅O₁₂:Ce; Ce-activated silicate phosphors such as Ca₃Sc₂Si₃O₁₂: Ce and Ca₃(Sc,Mg,Na,Li)₂Si₃O₁₂:Ce; Ce-activated oxide phosphors such as CaSc₂O₄:Ce; Eu-activated oxynitride phosphors such as SrSi₂O₂N₂:Eu, (Sr,Ba,Ca)Si₂O₂N₂:Eu, Eu-activated β-sialon and Eu-activated α-sialon; Eu,Mn-activated aluminate phosphors such as BaMgAl₁₀O₁₇:Eu,Mn; Eu-activated aluminate phosphors such as SrAl₂O₄:Eu; Tb-activated oxysulfide phosphors such as (La,Gd,Y)₂O₂S:Tb; Ce,Tb-activated phosphate phosphors such as LaPO₄:Ce,Tb; sulfide phosphors such as ZnS:Cu,Al and ZnS:Cu,Au,Al; Ce,Tb-activated borate phosphors such as (Y,Ga,Lu,Sc,La)BO₃:Ce,Tb, Na₂Gd₂B₂O₇:Ce,Tb and (Ba,Sr)₂(Ca,Mg,Zn)B₂O₆:K,Ce,Tb; Eu,Mn-activated halosilicate phosphors such as Ca₈Mg(SiO₄)₄Cl₂:Eu,Mn; Eu-activated thioaluminate phosphors or thiogallate phosphors such as (Sr,Ca,Ba) (Al,Ga,In)₂S₄:Eu, and Eu,Mn-activated halosilicate phosphors such as (Ca,Sr)₈(Mg,Zn) (SiO₄)₄Cl₂:Eu,Mn.

Other examples of the green phosphor include pyridine-phthalimide condensation derivatives, benzoxazinone-based, quinazolinone-based, coumarin-based, quinophthalone-based and naphthalimide-based fluorescent dyes; and organic phosphors such as terbium complexes having hexyl salicylate as a ligand.

### <<Blue Phosphor>>

Examples of the blue phosphor include europium-activated barium magnesium aluminate-based phosphors represented by BaMgAl₁₀O₁₇:Eu, which are composed of grown particles having a nearly hexagonal shape as the regular crystal growth shape, europium-activated calcium halophosphate-based phosphors represented by (Ca,Sr,Ba)₅(PO₄)₃Cl:Eu, which are composed of grown particles having a nearly spherical shapes as the regular crystal growth shape, europium-activated alkaline earth chloroborate-based phosphors represented by (Ca,Sr,Ba)₂B₅O₉Cl:Eu, which are composed of grown particles having a nearly cubic shapes as the regular crystal growth shape, and europium-activated alkaline earth aluminate-based phosphors represented by (Sr,Ca,Ba)Al₂O₄:Eu or (Sr,Ca,Ba)₄Al₁4O₂₅:Eu, which are composed of broken particles having broken surfaces.

Other examples of the blue phosphor include Sn-activated phosphate phosphors such as Sr₂P₂O₇:Sn; Eu-activated aluminate phosphors such as Sr₄Al₁₄O₂₅:Eu, BaMgAl₁₀O₁₇:Eu and BaAl₈O₁₃:Eu; Ce-activated thiogallate phosphors such as SrGa₂S₄:Ce and CaGa₂S₄:Ce; Eu-activated aluminate phosphors such as (Ba,Sr,Ca)MgAl₁₀O₁₇:Eu and BaMgAl₁₀O₁₇:Eu,Tb,Sm; Eu,Mn-activated aluminate phosphors such as (Ba,Sr,Ca)MgAl₁₀O₁₇:Eu,Mn; Eu-activated halophosphate phosphors such as (Sr,Ca,Ba,Mg)₁₀(PO₄)₆Cl₂:Eu and (Ba,Sr,Ca)₅(PO₄)₃(Cl,F,Br,OH):Eu,Mn,Sb; Eu-activated silicate phosphors such as BaAl₂Si₂O₈:Eu and (Sr,Ba)₃MgSi₂O₈:Eu; Eu-activated phosphate phosphors such as Sr₂P₂O₇:Eu; sulfide phosphors such as ZnS:Ag and ZnS:Ag,Al; Ce-activated silicate phosphors such as Y₂SiO₅:Ce; tungstate phosphors such as CaWO₄; Eu,Mn-activated borate phosphate phosphors such as (Ba,Sr,Ca)BPOs:Eu,Mn, (Sr,Ca)₁₀(PO₄)₆ · nB₂O₃:Eu and 2SrO · 0.84P₂O₅ · 0.16B₂O₃:Eu; and Eu-activated halosilicate phosphors such as Sr₂Si₃O₈ · 2SrCl₂:Eu.

Other examples of the blue phosphor include fluorescent dyes such as naphthalimide-based compounds, benzoxazole-based compounds, styryl-based compounds, coumarin-based compounds, pyralizone-based compounds and triazole-based compounds; organic phosphors such as thulium complexes; and the like.

### <<Quantum Dot>>

Examples of the quantum dots include InAs-based quantum dots, and CdE (E = S, Se, Te)-based quantum dots (CdSₓSe₁₋ₓ/ZnS, and the like) .

The average particle diameter of the wavelength conversion material contained in the wavelength conversion sheet of the present embodiment is preferably 0.1 to 100 µm, more preferably 1 to 50 µm, and further preferably 2 to 20 µm. When the average particle diameter of the wavelength conversion material is within this range, a more uniform wavelength conversion sheet is obtained.

In the wavelength conversion sheet of the present embodiment, the content of the wavelength conversion material is preferably 20% by mass or more and 95% by mass or less, more preferably 30% by mass or more and 90% by mass or less, further preferably 40% by mass or more and 85% by mass or less, and particularly preferably 50% by mass or more and 80% by mass or less, to the total content of the condensed silicone resin cured product and the wavelength conversion material.

### [Other Components]

The wavelength conversion sheet of the present embodiment may further contain an additive or the like, in addition to the condensed silicone resin cured product and the wavelength conversion material.

Further, the wavelength conversion sheet of the present embodiment may further contain inorganic particles. The inorganic particles can scatter light in the wavelength conversion sheet to excite the wavelength conversion material more effectively, and also can suppress sedimentation of the wavelength conversion material in a composition containing a condensed silicone resin at the stage of producing the wavelength conversion sheet.

Examples of the inorganic particles include oxides such as silicon, titanium, zirconia, aluminum, iron and zinc, carbon black, barium titanate, calcium silicate, and calcium carbonate. Among them, oxides such as silicon, titanium, zirconia and aluminum are preferable.

Examples of the shape of the inorganic particles include a substantially spherical shape, a plate shape, a column shape, a needle shape, a whisker shape and a fibrous shape, and a substantially spherical shape is preferable since a more uniform wavelength conversion sheet is obtained.

The inorganic particles contained in the wavelength conversion sheet of the present embodiment may be one type alone or two or more types. The size of the inorganic particles is preferably 1 to 20 µm and more preferably 1 to 10 µm.

The average particle size of primary particles of the inorganic particles can be determined, for example, by imaging method in which particles are directly observed with an electron microscope or the like.

Specifically, first, a liquid in which inorganic particles to be measured are dispersed in an any solvent is prepared, and the obtained dispersion is dropped on a slide glass or the like and dried. It may be prepared by directly spraying the inorganic particles on an adhesive surface of an adhesive tape to adhere the inorganic particles to the tape.

Next, the particles are directly observed with a scanning electron microscope (SEM) or a transmission electron microscope (TEM), and the dimension of the inorganic particles is determined from the obtained shape to determine the average particle size of primary particles of the inorganic particles.

The content of the inorganic particles is preferably 0.01 parts by mass or more and 100 parts by mass or less and more preferably 0.1 parts by mass or more and 50 parts by mass or less, to 100 parts by mass of the condensed silicone resin cured product contained in the wavelength conversion sheet of the present embodiment.

### [Wavelength Conversion Sheet]

The wavelength conversion sheet of the present embodiment has a storage modulus at 25°C of 2 GPa or more and 10 GPa or less.

When the wavelength conversion sheet has a storage modulus at 25°C of 2 GPa or more, occurrence of wrinkles, cracks and the like can be suppressed.

On the other hand, when the wavelength conversion sheet has a storage modulus at 25°C of 10 GPa or less, it is easy to produce a laminate including the wavelength conversion sheet and the substrate.

The wavelength conversion sheet of the present embodiment has a storage modulus at 25°C of preferably 2 GPa or more and 8 GPa or less, and more preferably 2.5 GPa or more and 6 GPa or less.

The wavelength conversion sheet of the present embodiment has a storage modulus at 150°C of 0.1 GPa or more and 5 GPa or less.

When the wavelength conversion sheet has a storage modulus at 150°C is 0.1 GPa or more, even in a case where the wavelength conversion sheet is exposed to a high temperature, mobility of the molecules constituting the condensed silicone resin cured product contained in the wavelength conversion sheet is suppressed and a deterioration reaction is suppressed, thus occurrence of coloration can be suppressed.

On the other hand, when the wavelength conversion sheet has a storage modulus at 150°C is 5 GPa or less, in a case where stress is loaded on the wavelength conversion sheet, the stress is moderately relaxed, so that crack generation when lowering the temperature from high temperature can be suppressed. As a result, light can be stably extracted from the wavelength conversion sheet.

The wavelength conversion sheet of the present embodiment has a storage modulus at 150°C of preferably 0.1 Pa or more and 3 GPa or less, more preferably 0.3 GPa or more and 2 GPa or less, and further preferably 0.5 GPa or more and 1.5 GPa or less.

In the present specification, the storage modulus of the wavelength conversion sheet is a value calculated by applying a strain or stress to a sample piece, and measuring a stress or strain generated against the strain or stress with a viscoelasticity measuring apparatus (for example, a viscoelasticity measuring apparatus DMA Q-800 manufactured by TA Instruments).

The thickness (film thickness) of the wavelength conversion sheet of the present embodiment is preferably 10 µm or more because the wavelength conversion sheet can be stably produced. Also, the thickness of the wavelength conversion sheet of the present embodiment is preferably 1 mm or less, more preferably 200 µm or less, and further preferably 100 µm or less, from the viewpoint of enhancing optical characteristics and heat resistance of the wavelength conversion sheet. When the thickness of the wavelength conversion sheet is 1 mm or less, light absorption and light scattering due to the condensed silicone resin cured product can be reduced.

The film thickness of the wavelength conversion sheet of the present embodiment can be obtained, for example, by measuring film thickness at a plurality of positions on the wavelength conversion sheet using a micrometer and calculating the average value thereof. For example, in a case where the shape of the wavelength conversion sheet is a quadrangle, the plurality of positions includes a total of five positions of one central position of the wavelength conversion sheet and four corner positions of the wavelength conversion sheet, and the like.

The wavelength conversion sheet of the present embodiment preferably has a Shore D hardness of 50 or more, and more preferably 60 or more.

In the present specification, the hardness measured by a type D durometer (rubber · plastic hardness tester) at a descending speed of 1 mm/sec was defined as the Shore D hardness.

The wavelength conversion sheet of the present embodiment can be suitably used for wavelength conversion sheets for solar cells, semiconductor lasers, LEDs, photodiodes, CCDs, CMOS, and the like. In particular, since the wavelength conversion sheet of the present embodiment has excellent heat resistance, it can be particularly suitably used for a wavelength conversion sheet for a light emitting portion of semiconductor laser requiring heat resistance.

The wavelength conversion sheet of the present embodiment has excellent heat resistance.

### <Laminate>

The laminate of the present embodiment includes the wavelength conversion sheet of the present embodiment and a substrate (support substrate) provided on one surface of the wavelength conversion sheet.

The support substrate may be appropriately selected according to the use of the laminate, but for example, a substrate using known metal, film, glass, ceramic, paper or the like as a forming material can be used.

Specific examples of materials for forming the support substrate include transparent inorganic oxide glass such as quartz glass, borosilicate glass and sapphire; metal plates or foils such as aluminum (including aluminum alloys), zinc, copper and iron; plastic films such as cellulose acetate, polyethylene terephthalate (PET), polyethylene, polyester, polyamide, polyimide, polyphenylene sulfide, polystyrene, polypropylene, polycarbonate, polyvinyl acetal and aramid; papers laminated with the above plastic; papers coated with the above plastic; papers laminated or deposited with the above metal; and plastic films laminated or deposited with the above metal. Among them, an inorganic oxide glass or a metal plate is preferable.

The thickness of the support substrate is preferably 30 µm or more, and more preferably 50 µm or more. When the thickness of the support substrate is 30 µm or more, it has sufficient strength to protect the shape of the wavelength conversion sheet. Also, the thickness of the support substrate is preferably 5000 µm or less, and more preferably 3000 µm or less, from the viewpoint of economy.

The laminate of the present embodiment has excellent heat resistance.

### <Method for Producing Wavelength Conversion Sheet>

A method for producing the wavelength conversion sheet of the present embodiment will be described.

The method for producing the wavelength conversion sheet of the present embodiment includes a preparation step S1, a molding step S2, a first heating step S3, and a second heating step S4.

### [Preparation Step S1]

In the preparation step S1, a wavelength conversion material-containing silicone resin composition containing a condensed silicone resin, a wavelength conversion material and a solvent is prepared.

### [Condensed Silicone Resin]

The condensed silicone resin contained in the wavelength conversion material-containing silicone resin composition may be one type alone or two or more types.

The condensed silicone resin contained in the wavelength conversion material-containing silicone resin composition preferably contains a structural unit represented by the formula (A3). In addition, the condensed silicone resin contained in the wavelength conversion material-containing silicone resin composition preferably further contains one or more structural units selected from the group consisting of a structural unit represented by the formula (A1), a structural unit represented by the formula (A1'), and a structural unit represented by the formula (A2).

The condensed silicone resin contained in the wavelength conversion material-containing silicone resin composition preferably contains all of the structural unit represented by the formula (A1), the structural unit represented by the formula (A1'), the structural unit represented by the formula (A2), and the structural unit represented by the formula (A3).

In the present specification, when the condensed silicone resin contained in the wavelength conversion material-containing silicone resin composition contains an oligomer component to be described later, the term "all structural units contained in the condensed silicone resin" includes a structural unit contained in an oligomer component.

In the condensed silicone resin contained in the wavelength conversion material-containing silicone resin composition, the total content of the structural unit represented by the formula (A1), the structural unit represented by the formula (A1'), the structural unit represented by the formula (A2) and the structural unit represented by the formula (A3) is preferably 50% by mole or more, more preferably 60% by mole or more, further preferably 70% by mole or more, particularly preferably 80% by mole or more, and more particularly preferably 90% by mole or more, to the total content of all structural units contained in the condensed silicone resin.

In other words, in the condensed silicone resin contained in the wavelength conversion material-containing silicone resin composition, the total content of the T1 unit, T2 unit and T3 unit is preferably 50% by mole or more, more preferably 60% by mole or more, further preferably 70% by mole or more, particularly preferably 80% by mole or more, and more particularly preferably 90% by mole or more, to the total content of all structural units contained in the condensed silicone resin.

In more other words, in the condensed silicone resin contained in the wavelength conversion material-containing silicone resin composition, the total content of T1 silicon atoms, T2 silicon atoms and T3 silicon atoms is preferably 50% by mole or more, more preferably 60% by mole or more, further preferably 70% by mole or more, particularly preferably 80% by mole or more, and more particularly preferably 90% by mole or more, to the total content of all silicon atoms contained in the condensed silicone resin.

In the condensed silicone resin contained in the wavelength conversion material-containing silicone resin composition, the content of the structural unit represented by the formula (A3) is preferably 55% by mole or more, more preferably 60% by mole or more, further preferably 65% by mole or more, and particularly preferably 70% by mole or more, to the total content of all structural units contained in the condensed silicone resin.

In other words, in the condensed silicone resin contained in the wavelength conversion material-containing silicone resin composition, the content of the T3 unit is preferably 50% by mole or more, to the total content of all structural units contained in the condensed silicone resin.

In other words, in the condensed silicone resin contained in the wavelength conversion material-containing silicone resin composition, the content of T3 silicon atoms is 50% by mole or more, to the total content of all silicon atoms contained in the condensed silicone resin.

In the condensed silicone resin contained in the wavelength conversion material-containing silicone resin composition, when the content of the structural unit represented by the formula (A3) is within this range, the storage modulus at room temperature (25°C) and the storage modulus at high temperature (150°C) of the obtained wavelength conversion sheet can be controlled within a desired range.

That is, in the condensed silicone resin contained in the wavelength conversion material-containing silicone resin composition, the content of the T3 unit is preferably 55% by mole or more, more preferably 60% by mole or more, further preferably 65% by mole or more, and particularly preferably 70% by mole or more, to the total content of all structural units contained in the condensed silicone resin. In other words, in the condensed silicone resin contained in the wavelength conversion material-containing silicone resin composition, the content of T3 silicon atoms is preferably 55% by mole or more, more preferably 60% by mole or more, further preferably 65% by mole or more, and particularly preferably 70% by mole or more, to the total content of all silicon atoms contained in the condensed silicone resin.

As described later in the examples, in the condensed silicone resin contained in the wavelength conversion material-containing silicone resin composition, when the content of the T unit and the content of the T3 unit are within the above ranges, a wavelength conversion sheet obtained by using the wavelength conversion material-containing silicone resin composition shows sufficient heat resistance and also shows high light transmittance even after a heat resistance test. That is, the wavelength conversion sheet obtained by using the wavelength conversion material-containing silicone resin composition has excellent crack resistance and is hardly discolored.

In the condensed silicone resin contained in the wavelength conversion material-containing silicone resin composition, the content of the D unit is preferably 30% by mole or less, more preferably 20% by mole or less, further preferably 10% by mole or less, particularly preferably 5% by mole or less, and more particularly preferably 4% by mole or less, to the total content of all structural units contained in the condensed silicone resin.

The content of the T3 silicon atoms contained in the condensed silicone resin can be obtained by dividing an area of a signal assigned as the T3 silicon atom by a total area of signals of all silicon atoms determined in the ²⁹Si-NMR measurement. The content of silicon atoms (T1 silicon atoms and T2 silicon atoms) other than T3 silicon atoms can also be determined in the same manner.

The condensed silicone resin contained in the wavelength conversion material-containing silicone resin composition may further contain a structural unit represented by the formula (C1), formula (C1'), formula (C2), formula (C3) or formula (C4).

The polystyrene equivalent weight average molecular weight of the condensed silicone resin contained in the wavelength conversion material-containing silicone resin composition is usually 1500 to 15000, preferably 2000 to 10000, and more preferably 2000 to 8000. When the polystyrene equivalent weight average molecular weight of the condensed silicone resin is within the above range, solubility of the condensed silicone resin in a solvent is improved and handling properties and coating properties when using the wavelength conversion material-containing silicone resin composition are improved.

Generally, the weight average molecular weight of the silicone resin can use a value measured by a gel permeation chromatography (GPC) method. Specifically, after dissolving the silicone resin in a soluble solvent, the obtained solution is passed through a column using a filler in which many pores are present together with a mobile phase solvent to separate the silicone resin in the column depending on the levels of the molecular weight. The content of the separated molecular weight component is detected by using a differential refractometer, a UV meter, a viscometer, a light scattering detector or the like as a detector. A dedicated GPC instrument is widely commercially available, and the weight average molecular weight is generally measured in terms of standard polystyrene. The weight average molecular weight in this specification is measured in terms of standard polystyrene.

### (Silicone Resin A)

The condensed silicone resin contained in the wavelength conversion material-containing silicone resin composition is preferably a mixture of a silicone resin (hereinafter sometimes referred to as "silicone resin A") as a main agent and a silicone resin for modification (oligomer component) described later.

The silicone resin A preferably contains the structural unit represented by the formula (A3). Further, the silicone resin A preferably further contains one or more structural units selected from the group consisting of the structural unit represented by the formula (A1), the structural unit represented by the formula (A1'), and the structural unit represented by the formula (A2).

In the silicone resin A, the total content of the T1 unit, T2 unit and T3 unit is usually 70% by mole or more to the total content of all structural units of the silicone resin A.

In the silicone resin A, the content of the T3 unit is usually 60% by mole or more and 90% by mole or less to the total content of all structural units of the silicone resin A.

The polystyrene equivalent weight average molecular weight of the silicone resin A is usually 1500 or more and 8000 or less.

In the silicone resin A, the total content of the T1 unit, T2 unit and T3 unit is preferably 80% by mole or more, more preferably 90% by mole or more, and further preferably 95% by mole or more, to the total content of all structural units of the silicone resin A.

In the silicone resin A, the content of the T3 unit is preferably 65% or more and 90% or less, and more preferably 70% or more and 85% or less, to the total content of all structural units of the silicone resin A.

The polystyrene equivalent weight average molecular weight of the silicone resin A is preferably 1500 or more and 7000 or less, and more preferably 2000 or more and 5000 or less.

As the silicone resin A, a commercially available silicone resin can be used.

The silicone resin A preferably has a silanol group (Si-OH). In the silicone resin A, a silicon atom having a silanol group is preferably 1 to 30% by mole, more preferably 5 to 27% by mole, and further preferably 10 to 25% by mole, to all silicon atoms contained in the silicone resin A. In the silicone resin A, when the content of the silicon atoms having a silanol group is within the above range, hydrogen bonds are formed between the silicone resin A and a surface of the wavelength conversion material. Therefore, mixing performance with the wavelength conversion material is improved. In addition, since a curing reaction of the wavelength conversion material-containing silicone resin composition of the present embodiment easily proceeds, a wavelength conversion sheet with high heat resistance can be obtained.

Further, in the silicone resin A, a silicon atom having an alkoxy group is preferably more than 0% by mole and 20% by mole or less, more preferably more than 0% by mole and 10% by mole or less, and further preferably 1% by mole or more and 10% by mole or less, to all silicon atoms contained in the silicone resin A. In the silicone resin A, when the content of the silicon atoms having an alkoxy group is within the above range, the wavelength conversion material-containing silicone resin composition has good storage stability and fluidity is within an appropriate range, thus handling properties of the wavelength conversion material-containing silicone resin composition is improved.

The silicone resin A can be synthesized using an organosilicon compound having a functional group capable of forming a siloxane bond as a starting material. Here, examples of the "functional group capable of forming a siloxane bond" include a halogen atom, a hydroxyl group, and an alkoxy group. Examples of the organosilicon compound corresponding to the structural unit represented by the formula (A3) include organotrihalosilanes, organotrialkoxysilanes, and the like. The silicone resin A can be synthesized by reacting an organosilicon compound as the starting material in a ratio corresponding to the abundance ratio of each structural unit by a hydrolysis condensation method, in the presence of an acid such as hydrochloric acid or a base such as sodium hydroxide. By appropriately selecting the organosilicon compound as the starting material, the abundance ratio of T3 silicon atoms contained in the silicone resin A can be adjusted.

The content of the silicone resin A is preferably 60% by mass to 100% by mass, and more preferably 70 to 95% by mass, to the total content of all condensed silicone resins contained in the wavelength conversion material-containing silicone resin composition.

### [Silicone for Modification]

In addition to the silicone resin A, the condensed silicone resin contained in the wavelength conversion material-containing silicone resin composition may contain the following silicone for modification (oligomer component). By including the silicone for modification in the condensed silicone resin, the wavelength conversion sheet of the present embodiment has excellent flexibility and crack resistance.

### <<Oligomer B>>

Specific examples of the silicone for modification include oligomers containing a structural unit represented by the following formula (B1), formula (B1'), formula (B2) or formula (B3). 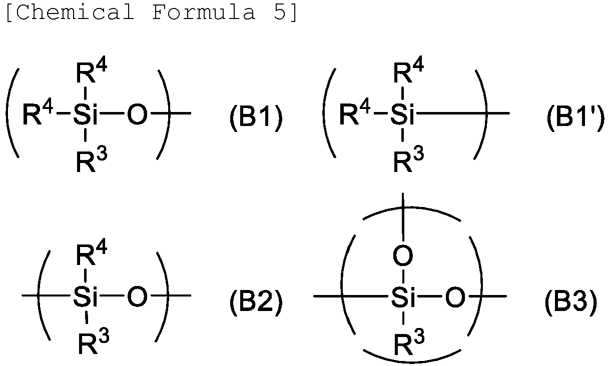 In the formulas (B1), (B1'), (B2) and (B3),
R³ represents an alkyl group having 1 to 10 carbon atoms or an aryl group having 6 to 10 carbon atoms;
R⁴ represents an alkyl group having 1 to 10 carbon atoms, an aryl group having 6 to 10 carbon atoms, an alkoxy group having 1 to 4 carbon atoms or a hydroxyl group; and
a plurality of R³s and R⁴s each may be the same or different,

The polystyrene equivalent weight average molecular weight of the oligomer containing the structural units represented by the formula (B1), the formula (B1'), the formula (B2) or the formula (B3) is preferably 1000 to 10000, more preferably 2000 to 8000, and further preferably 3000 to 6000.

In the following description, a silicone for modification containing the structural units represented by the formula (B1), the formula (B1'), the formula (B2) or the formula (B3) and having a polystyrene equivalent weight average molecular weight of 1000 to 10000 is referred to as "oligomer B".

The oligomer B is preferably (a) an oligomer containing a T2 unit or (b) an oligomer containing a D unit, and more preferably an oligomer satisfying (a) and (b), that is, (c) an oligomer containing a T2 unit and a D unit.

### (a) Oligomer containing T2 unit

As the oligomer containing a T2 unit (a), one having a content of the structural unit represented by the formula (B2) contained in the first oligomer in which R⁴ is an alkoxy group having 1 to 4 carbon atoms or a hydroxyl group, that is, a content of the T2 unit, of 30 to 60% by mole is preferable, and of 40 to 55% by mole is more preferable.

In the case where the oligomer B is an oligomer containing a T2 unit (a), when the content of the T2 unit is within the above-described range, the wavelength conversion material-containing silicone resin composition exhibits good curing reactivity during thermal curing while securing solubility of the silicone resin A and the oligomer B.

### (b) Oligomer containing D unit

As the oligomer containing a D unit (b), a silicone resin containing a structural unit represented by the formula (B1), the formula (B1'), the formula (B2) or the formula (B3) in which the average composition formula is represented by the following formula (I) is preferable.

(R⁵)ₙSi(OR⁶)ₘO_{(4-n-m)/2} ... (I)

In the formula (I), R⁵ represents an alkyl group having 1 to 10 carbon atoms or an aryl group having 6 to 10 carbon atoms;
R⁶ represents an alkyl group having 1 to 10 carbon atoms, an aryl group having 6 to 10 carbon atoms or a hydrogen atom;
n represents a real number satisfying 1 < n < 2; and m represents a real number satisfying 0 < m < 1.

An oligomer B having an average composition formula represented by the formula (I) contains the "T unit" and "D unit" described above.

In the formula (I), R⁵ is preferably a methyl group, and R⁶ is preferably a methyl group or a hydrogen atom. It is preferable that n is a real number satisfying 1 < n ≤ 1.5 and m is a real number satisfying 0.5 ≤ m < 1, and it is more preferable that n is a real number satisfying 1.1 ≤ n ≤ 1.4 and m is a real number satisfying 0.55 ≤ m ≤ 0.75. When n and m in the formula (I) are within these ranges, compatibility between the oligomer B and the silicone resin A is improved.

Among all structural units contained in the oligomer B, the structural unit represented by the formula (B1) and the structural unit represented by the formula (B1') in which one of two R⁴s is an alkyl group having 1 to 10 carbon atoms or an aryl group having 6 to 10 carbon atoms and the other is an alkoxy group having 1 to 4 carbon atoms or a hydroxyl group is a "D1 unit".

Among all structural units contained in the oligomer B, the structural unit represented by the formula (B2) in which R⁴ is an alkyl group having 1 to 10 carbon atoms or an aryl group having 6 to 10 carbon atoms is a "D2 unit".

In the case where the oligomer B is an oligomer containing a D unit (b), among all structural units contained in the oligomer B, the total content of the D1 unit and the D2 unit is preferably 5 to 80% by mole, more preferably 10 to 70% by mole, and further preferably 15 to 50% by mole.

### (c) Oligomer containing T2 unit and D unit

The oligomer containing a T2 unit and a D unit (c) satisfies requirements of both the oligomer containing a T2 unit (a) and the oligomer containing a D unit (b).

Among all structural units contained in the oligomer B, the structural unit represented by the formula (B1) and the structural unit represented by the formula (B1') in which two R⁴s are an alkoxy group having 1 to 4 carbon atoms or a hydroxyl group is a T1 unit.

Among all structural units contained in the oligomer B, the structural unit represented by the formula (B2) in which R⁴ is an alkoxy group having 1 to 4 carbon atoms or a hydroxyl group is a T2 unit.

Among all structural units contained in the oligomer B, the structural unit represented by the formula (B3) is a T3 unit.

In the case where the oligomer B is an oligomer containing a T2 unit and a D unit (c), among all structural units contained in the oligomer B, the molar ratio of the total content of the T1 unit, the T2 unit and the T3 unit to the content of the D unit (T unit : D unit) is preferably 60 : 40 to 90 : 10, and more preferably 75 : 25 to 85 : 15. When the molar ratio of T unit : D unit is within the above range, compatibility between the silicone resin A and the oligomer B is improved.

The oligomer B corresponds to each of the above-described structural units constituting the silicone resin and can be synthesized using an organosilicon compound having a functional group capable of generating a siloxane bond as a starting material. Here, examples of the "functional group capable of forming a siloxane bond" include a halogen atom, a hydroxyl group, and an alkoxy group. Examples of the organosilicon compound corresponding to the structural unit represented by the formula (B3) include organotrihalosilanes, organotrialkoxysilanes, and the like. Examples of the organosilicon compound corresponding to the structural unit represented by the formula (B2) include organodihalosilanes, organodialkoxysilanes, and the like.

The oligomer B can be synthesized by reacting an organosilicon compound as the starting material in a ratio corresponding to the abundance ratio of each structural unit by a hydrolysis condensation method, in the presence of an acid such as hydrochloric acid or a base such as sodium hydroxide. By appropriately selecting the organosilicon compound as the starting material, the abundance ratio of silicon atoms of the T unit and silicon atoms of the D unit contained in the oligomer B can be adjusted.

In the molecular weight distribution of the oligomer B measured by a GPC method, single or multiple peaks may exist. In the molecular weight distribution of the oligomer B, the sum of areas of peaks present in a region with a polystyrene equivalent weight average molecular weight of 7500 or more to the sum of areas of all peaks may be 20% or more, and the sum of areas of peaks present in a region with a polystyrene equivalent weight average molecular weight of 1000 or less to the sum of areas of all peaks may be 30% or more.

The content of the oligomer B is preferably 0.1 to 20% by mass, more preferably 0.2 to 15% by mass, and further preferably 0.5 to 10% by mass, to the total content of silicone resins contained in the wavelength conversion material-containing silicone resin composition.

Also, the content of the oligomer B is preferably from 0.1 to 20% by mass, more preferably from 1 to 15% by mass, and further preferably from 5 to 12% by mass, to the content of the silicone resin A.

### (Oligomer C)

Other examples of the silicone for modification include silicone resins containing the structural unit represented by the formula (A1), formula (A1'), formula (A2) or formula (A3) in which the content of the structural unit represented by the formula (A3), to the total content of the structural unit represented by the formula (A1), the structural unit represented by the formula (A1'), the structural unit represented by the formula (A2) and the structural unit represented by the formula (A3), is 0 to 30% by mole, and the polystyrene equivalent weight average molecular weight is less than 1500.

In the following description, such silicone resin is referred to as "oligomer C".

The oligomer C is a silicone resin containing one or more structural units of the structural unit represented by the formula (A1), the structural unit represented by the formula (A1'), the structural unit represented by the formula (A2) and the structural unit represented by the formula (A3), and may be a silicone resin containing all four structural units.

The oligomer C is a silicone resin having a ratio of the content of the T3 silicon atoms to the total content of the T1 silicon atoms, the T2 silicon atoms and the T3 silicon atoms of 0 to 30% by mole, and a polystyrene equivalent weight average molecular weight of less than 1500. The ratio of the content of the T3 silicon atoms to the total content of the T1 silicon atoms, the T2 silicon atoms and the T3 silicon atoms is preferably 0 to 25% by mole.

The oligomer C preferably has substantially no silicon atom bonded to a hydrogen atom (hydrosilyl group) and silicon atom bonded to an alkenyl group. When the oligomer C has a silicon atom bonded to a hydrogen atom (hydrosilyl group) or a silicon atom bonded to an alkenyl group, heat resistance of the wavelength conversion sheet of the present embodiment is lowered.

The oligomer C is preferably an oligomer having an organopolysiloxane structure represented by the following formula (1). 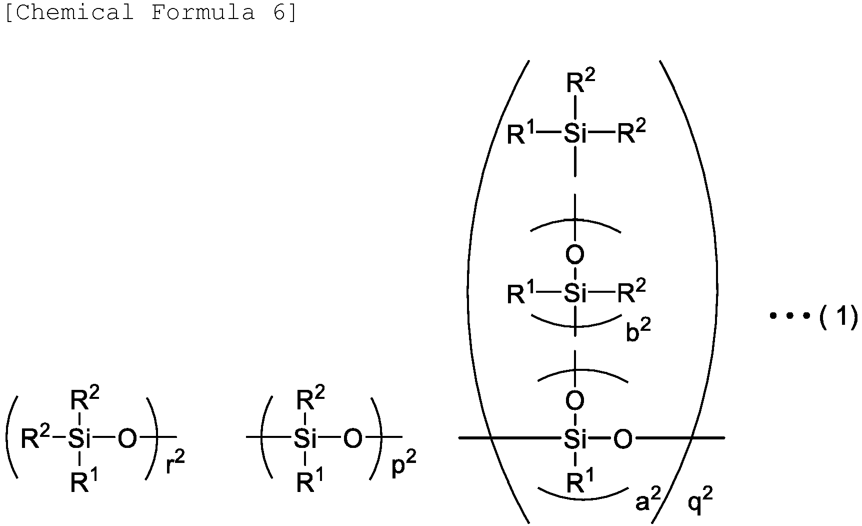
In the formula (1), R¹ and R² have the same meaning as described above, a plurality of R¹s and R²s each may be the same or different, and
p², q², r², a² and b² represent any numbers equal to or greater than 0 such that [a² × q²] / [(p² + b² × q²) + a² × q² + (r² + q²)] = 0 to 0.3.

In the organopolysiloxane structure represented by the formula (1), it is preferable that R¹s are one or more groups selected from the group consisting of a methyl group, an ethyl group and a phenyl group, and R²s are one or more groups selected from the group consisting of a methoxy group, an ethoxy group, an isopropoxy group and a hydroxyl group, and it is more preferable that R¹s are one or more groups selected from the group consisting of a methyl group and an ethyl group, and R²s are one or more groups selected from the group consisting of a methoxy group, an ethoxy group and an isopropoxy group. From the viewpoint of heat resistance of the wavelength conversion sheet of the present embodiment, R¹s are preferably a methyl group.

The abundance ratio of each structural unit of the oligomer C having the organopolysiloxane structure represented by the formula (1) can be represented by the abundance ratio of the T1 silicon atoms, the T2 silicon atoms, and the T3 silicon atoms. That is, T1 silicon atoms : T2 silicon atoms : T3 silicon atoms = [r² + q²] : [p² + b² × q²] : [a² × q²]. The abundance ratio of each silicon atom in the oligomer C can be adjusted by appropriately adjusting the numerical values of p², q², r², a² and b². For example, when at least one of a² and q² is 0, a T3 silicon atom is not present in the oligomer C, and only linear or cyclic molecules are contained. On the other hand, when both r² and q² are 0, only T2 silicon atoms are present in the oligomer C and only cyclic molecules are contained.

In the organopolysiloxane structure represented by the formula (1), when the number of T2 silicon atoms is x₂, the number of T3 silicon atoms is y₂, and the number of T1 silicon atoms is z₂, the abundance ratio of the T3 silicon atoms in the organopolysiloxane structure represented by the formula (2) is represented by [y₂/(x₂ + y₂ + z₂)].

[a² × q²] / [(p² + b² × q²) + a² × q² + (r² + q²)] is equal to the abundance ratio of the T3 silicon atoms in the organopolysiloxane structure represented by the formula (1) : [y₂/(x₂ + y₂ + z₂)]. That is, p², q², r², a² and b² in the formula (2) are appropriately adjusted so that the abundance ratio of the T3 silicon atoms is within the range of 0 to 0.3.

The oligomer C which may be contained in the wavelength conversion material-containing silicone resin composition is a silicone resin having the organopolysiloxane structure represented by the formula (1), and is preferably an oligomer having a ratio of the content of the T3 silicon atoms to the total content of the T1 silicon atoms, the T2 silicon atoms and the T3 silicon atoms: [y₂/(x₂ + y₂ + z₂)] of 0 to 0.3, and a polystyrene equivalent weight average molecular weight of less than 1500. When the abundance ratio of the T3 silicon atoms is within this range, the abundance ratio of the T2 silicon atoms: [x₂/(x₂ + y₂ + z₂)] and the abundance ratio of the T1 silicon atoms: [z₂/(x₂ + y₂ + z₂)] are not particularly limited. As the oligomer C, one having [y₂/(x₂ + y₂ + z₂)] within the range of 0 to 0.25 is preferable, and within the range of 0.05 to 0.2 is more preferable.

The oligomer C has a relatively low abundance ratio of the T3 silicon atoms, and thus contains few branched chain structures and many linear or cyclic molecules. The oligomer C may contain only cyclic molecules, but preferably contains many linear molecules. As the oligomer C, for example, one in which the abundance ratio of the T1 silicon atoms: [z₂/(x₂ + y₂ + z₂)] is within the range of 0 to 0.80, more preferably within the range of 0.30 to 0.80, further preferably within the range of 0.35 to 0.75, and particularly preferably within the range of 0.35 to 0.55.

The polystyrene equivalent weight average molecular weight of the oligomer C measured by the GPC method is less than 1500. When the polystyrene equivalent weight average molecular weight of the oligomer C is too large, crack resistance of the wavelength conversion sheet of the present embodiment may be insufficient in some cases. The polystyrene equivalent weight average molecular weight of the oligomer C may be less than 1000.

The number of T1 silicon atoms, T2 silicon atoms and T3 silicon atoms in one molecule of the oligomer C is appropriately adjusted so that the resin having the organopolysiloxane structure represented by the formula (2) has a desired molecular weight. In one embodiment, the sum of the number of T1 silicon atoms, the number of T2 silicon atoms and the number of T3 silicon atoms in one molecule of the oligomer C is preferably 2 or more.

The oligomer C corresponds to each of the above-described structural units constituting the oligomer C and can be synthesized using an organosilicon compound having a functional group capable of generating a siloxane bond as a starting material. Here, the "functional group capable of forming a siloxane bond" has the same meaning as one described above. Examples of the organosilicon compound corresponding to the structural unit represented by the formula (A3) include organotrihalosilanes, organotrialkoxysilanes, and the like. The oligomer C can be synthesized by reacting such organosilicon compound as the starting material in a ratio corresponding to the abundance ratio of each structural unit by a hydrolysis condensation method.

Upon synthesis of the oligomer C, an organosilicon compound corresponding to the structural unit represented by the formula (A1) and an organosilicon compound corresponding to the structural unit represented by the formula (A1') are mixed as the starting material. When these organosilicon compounds are polymerized by hydrolysis condensation reaction, the organosilicon compounds are bound to the end of the polymerization reaction to stop the polymerization reaction.

The content of the oligomer C is preferably 0.1 to 20% by mass, more preferably 0.2 to 15% by mass, and further preferably 0.5 to 10% by mass, to the total content of silicone resins contained in the wavelength conversion material-containing silicone resin composition.

Also, the content of the oligomer C is preferably from 0.1 to 20% by mass, more preferably from 0.3 to 10% by mass, and further preferably from 0.5 to 5% by mass, to the content of the silicone resin A.

The condensed silicone resin contained in the wavelength conversion material-containing silicone resin composition preferably contains the oligomer B or the oligomer C in addition to the silicone resin A, and more preferably the silicone resin A, the oligomer B and the oligomer C.

The wavelength conversion material-containing silicone resin composition preferably contains the silicone resin A, a solvent, a wavelength conversion material, and the oligomer B or the oligomer C, and more preferably contains the silicone resin A, a solvent, a wavelength conversion material, the oligomer B, and the oligomer C.

Other examples of the silicone for modification include silicone resins containing the structural unit represented by the formula (A1) and the structural unit represented by the formula (A2). The silicone resin is a silicone resin containing a D unit.

### [Wavelength Conversion Material]

The wavelength conversion material contained in the wavelength conversion material-containing silicone resin composition is the same as the wavelength conversion material contained in the wavelength conversion sheet of the present embodiment. The wavelength conversion material easily settles in the wavelength conversion material-containing silicone resin composition. In order to suppress sedimentation of the wavelength conversion material, it is preferable to mix other materials contained in the wavelength conversion material-containing silicone resin composition in advance and then mix the wavelength conversion material.

### [Solvent]

The condensed silicone resin contained in the wavelength conversion material-containing silicone resin composition has high content of the T3 unit, and thus contains a solvent for the purpose of improving handling properties. Hereinafter, a composition containing a condensed silicone resin and a solvent and not containing a wavelength conversion material is referred to as a "condensed silicone resin composition".

The solvent is not particularly limited as long as it can dissolve the silicone resin (silicone resin A) and the oligomers (oligomer B and oligomer C). Since the silicone resin and the oligomers can be uniformly mixed and stability of the condensed silicone resin composition and the wavelength conversion material-containing silicone resin composition can be improved, it is preferable to use two or more types of solvents having different boiling points (hereinafter referred to as a solvent P and a solvent Q) as the solvents.

As the solvent P, an organic solvent having a boiling point of lower than 100°C is preferable. Specifically, ketone solvents such as acetone and methyl ethyl ketone; alcohol solvents such as methanol, ethanol, isopropyl alcohol and normal propyl alcohol; hydrocarbon solvents such as hexane, cyclohexane, heptane and benzene; ester acetate solvents such as ethyl acetate; and ether solvents such as diethyl ether and tetrahydrofuran are preferable.

Among them, alcohol solvents such as methanol, ethanol, isopropyl alcohol and normal propyl alcohol are more preferable as the solvent P.

As the solvent Q, an organic solvent having a boiling point of 100°C or more is preferable. Specifically, glycol ether solvents, glycol ester solvents and the like are preferable.

Specific examples of the glycol ether solvents include ethylene glycol monomethyl ether, ethylene glycol monoethyl ether, ethylene glycol monoisopropyl ether, ethylene glycol monobutyl ether, ethylene glycol monohexyl ether, ethylene glycol monoethylhexyl ether, ethylene glycol monophenyl ether, ethylene glycol monobenzyl ether, diethylene glycol monomethyl ether, diethylene glycol monoethyl ether, diethylene glycol monoisopropyl ether, diethylene glycol monobutyl ether, diethylene glycol monohexyl ether, diethylene glycol monoethylhexyl ether, diethylene glycol monophenyl ether, diethylene glycol monobenzyl ether, propylene glycol monomethyl ether, propylene glycol monoethyl ether, propylene glycol monoisopropyl ether, propylene glycol monobutyl ether, propylene glycol monohexyl ether, propylene glycol monoethylhexyl ether, propylene glycol monophenyl ether, propylene glycol monobenzyl ether, dipropylene glycol monomethyl ether, dipropylene glycol monoethyl ether, dipropylene glycol monoisopropyl ether, dipropylene glycol monobutyl ether, dipropylene glycol monohexyl ether, dipropylene glycol monoethylhexyl ether, dipropylene glycol monophenyl ether, and dipropylene glycol monobenzyl ether.

Specific examples of the glycol ester solvents include ethylene glycol monoethyl ether acetate, ethylene glycol monoisopropyl ether acetate, ethylene glycol monobutyl ether acetate, ethylene glycol monohexyl ether acetate, ethylene glycol monoethylhexyl ether acetate, ethylene glycol monophenyl ether acetate, and ethylene glycol monobenzyl ether acetate.

Among them, ethylene glycol monobutyl ether, dipropylene glycol monomethyl ether, diethylene glycol monobutyl ether and ethylene glycol monobutyl ether acetate are more preferable as the solvent Q.

The viscosity of the condensed silicone resin composition is preferably 100 to 500000 mPa·s at 25°C.

In the wavelength conversion material-containing silicone resin composition, the content of the solvent is preferably 10 to 40% by mass, to the total content of all components contained in the wavelength conversion material-containing silicone resin composition. When the content of the solvent is within the above range, the viscosity of the wavelength conversion material-containing silicone resin composition is easily adjusted within a range where coating properties are improved.

Since the wavelength conversion material-containing silicone resin composition easily suppresses sedimentation of the wavelength conversion material and has good coating properties, it is preferably a liquid composition having a viscosity of 1000 to 500000 mPa·s at 25°C.

When the viscosity of the wavelength conversion material-containing silicone resin composition at 25°C is within the above range, the wavelength conversion material-containing silicone resin composition is easily applied on a substrate by, for example, screen printing or the like. In addition, in the wavelength conversion material-containing silicone resin composition, it is easy to remove the solvent and air bubbles during heat curing. Therefore, a wavelength conversion sheet with high heat resistance can be obtained. The viscosity of the wavelength conversion material-containing silicone resin composition can be measured, for example, by a cone-plate type E type viscometer, by a method of detecting resistance (viscous resistance) that the cone plate receives from a fluid by rotational torque.

The viscosity at 25°C of the wavelength conversion material-containing silicone resin composition is preferably from 8000 to 100000 mPa·s, and further preferably from 10000 to 80000 mPa·s. When the viscosity of the wavelength conversion material-containing silicone resin composition is within this range, coating properties are improved.

In the conventional wavelength conversion material-containing silicone resin composition, dispersibility of the wavelength conversion material is maintained by adding an anti-settling agent such as silica. On the other hand, in the wavelength conversion material-containing silicone resin composition, when the viscosity is within the above range, sedimentation of the wavelength conversion material can be suppressed even without adding an anti-settling agent.

### (Silica Particles)

It is preferable that the wavelength conversion material-containing silicone resin is substantially free of silica particles. Here, the phrase "substantially free of silica particles" means a form that the wavelength conversion material-containing silicone resin composition does not contain silica particles at all and a form that contains silica particles on a level that does not decrease light transmissivity of the cured product of the wavelength conversion material-containing silicone resin composition. Here, the phrase "on a level that does not decrease light transmissivity of the cured product" means that the degree of decrease in light transmissivity is a practically acceptable level. Specifically, it means that the degree of decrease in light transmissivity of the cured product of the wavelength conversion material-containing silicone resin composition containing silica particles is 10% or less, and preferably 5% or less, to the light transmissivity of the cured product of the wavelength conversion material-containing silicone resin composition not containing silica particles. In the wavelength conversion material-containing silicone resin composition, the content of the silica particles is preferably about 1% by mass or less, and more preferably 0.1% by mass or less.

Since the wavelength conversion material-containing silicone resin is substantially free of silica particles, when the cured product of the wavelength conversion material-containing silicone resin composition is applied to the wavelength conversion material of a semiconductor light-emitting device, it can suppress decrease in light transmissivity of the matrix resin forming the wavelength conversion material. As a result, reduction in the light extraction efficiency of the semiconductor light-emitting device is suppressed, and reduction in light output of the semiconductor light-emitting device can be suppressed.

### [Other Materials]

The wavelength conversion material-containing silicone resin composition may contain various materials as necessary. The wavelength conversion material-containing silicone resin composition may contain additives such as inorganic particles and adhesion aid, for example, in order to improve diffusion and coating properties of the wavelength conversion material. The wavelength conversion material-containing silicone resin composition preferably contains a curing catalyst or a silane coupling agent.

### (Curing Catalyst)

As the curing catalyst, for example, when R²s in the structural unit represented by the formula (A1), the structural unit represented by the formula (A1') and the structural unit represented by the formula (A2) are an alkoxy group or a hydroxyl group, an inorganic acid such as hydrochloric acid, sulfuric acid, nitric acid, or phosphoric acid; or an organic acid such as formic acid, acetic acid, oxalic acid, citric acid, propionic acid, butyric acid, lactic acid or succinic acid can be used, in order to accelerate hydrolysis condensation reaction.

As the curing catalyst, not only an acidic compound but also an alkaline compound can be used. Specifically, ammonium hydroxide, tetramethylammonium hydroxide, tetraethylammonium hydroxide or the like can be used as the curing catalyst.

As the curing catalyst, an organometallic compound catalyst can also be used. Specifically, as the curing catalyst, an organometallic compound catalyst containing aluminum, zirconium, tin, titanium or zinc can be used.

Examples of the organometallic compound catalyst containing aluminum include aluminum triacetylacetate and aluminum triisopropoxide.

Examples of the organometallic compound catalyst containing zirconium include zirconium tetraacetylacetonate, zirconium tributoxyacetylacetonate, zirconium dibutoxydiacetylacetonate, zirconium tetranormalbutoxide, zirconium tetraisopropoxide, zirconium tetranormalbutoxide, zirconium acylate, and zirconium tributoxystearate.

Examples of the organometallic compound catalyst containing tin include tetrabutyltin, monobutyltin trichloride, dibutyltin dichloride, dibutyltin oxide, tetraoctyltin, dioctyltin dichloride, dioctyltin oxide, tetramethyltin, dibutyltin laurate, dioctyltin dilaurate, bis(2-ethylhexanoate)tin, bis(neodecanoate)tin, di-n-butylbis(ethylhexylmalate)tin, di-normalbutylbis(2,4-pentanedionate)tin, di-normalbutyl butoxy chlorotin, di-normalbutyl diacetoxytin, di-normalbutyltin dilaurate, and dimethyltin dineodecanoate.

Examples of the organometallic compound catalyst containing titanium include titanium tetraisopropoxide, titanium tetranormalbutoxide, butyl titanate dimer, tetraoctyl titanate, titanium acetylacetonate, titanium octylene glycolate, and titanium ethyl acetoacetate.

Examples of the organometallic compound catalyst containing zinc include zinc triacetylacetonate.

Among them, phosphoric acid ester or phosphoric acid is preferable, and phosphoric acid is particularly preferable.

In order to add the curing catalyst to the wavelength conversion material-containing silicone resin composition at a predetermined concentration, it is preferable to dilute the curing catalyst into water, an organic solvent, a silicone-based monomer, an alkoxysilane oligomer or the like and then add it to the wavelength conversion material-containing silicone resin composition.

The content of the curing catalyst can be appropriately adjusted in consideration of the heating temperature and time of the curing reaction of the wavelength conversion material-containing silicone resin composition, the type of catalyst, and the like. The content of the curing catalyst is preferably 0.01 parts by mass or more and 10 parts by mass or less, more preferably 0.01 parts by mass or more and 5 parts by mass or less, and further preferably 0.1 parts by mass or more and 1 part by mass or less, to 100 parts by mass of the wavelength conversion material-containing silicone resin composition.

The curing catalyst may be added to the wavelength conversion material-containing silicone resin composition beforehand or may be added to the wavelength conversion material-containing silicone resin composition immediately before performing the curing reaction of the wavelength conversion material-containing silicone resin composition.

### (Silane Coupling Agent)

As the silane coupling agent, for example, a silane coupling agent having at least one or more selected from the group consisting of a vinyl group, an epoxy group, a styryl group, a methacryl group, an acryl group, an amino group, an ureido group, a mercapto group, a sulfide group and an isocyanate group is preferable. Among them, a silane coupling agent having an epoxy group or a mercapto group is preferable.

Specific examples of the silane coupling agent include 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, 3-mercaptopropylmethyldimethoxysilane, and 3-mercaptopropyltrimethoxysilane.

When a silane coupling agent is contained in the wavelength conversion material-containing silicone resin composition, the silicon atom contained in the silane coupling agent is also detected as a signal of ²⁹Si-NMR, but in the present specification, the signal of the silane coupling agent is also included when calculating the signal area of the wavelength conversion material-containing silicone resin composition.

The content of the silane coupling agent is preferably 0.0001 parts by mass or more and 1.0 part by mass or less, and more preferably 0.001 parts by mass or more and 0.1 parts by mass or less, to 100 parts by mass of the condensed silicone resin contained in the wavelength conversion material-containing silicone resin composition.

### (Inorganic Particles)

The inorganic particles contained in the wavelength conversion material-containing silicone resin composition are the same as the inorganic particles which may be contained in the wavelength conversion sheet of the present embodiment. The inorganic particles can scatter light in the wavelength conversion sheet to excite the wavelength conversion material more effectively, and also can suppress sedimentation of the wavelength conversion material in a composition containing a condensed silicone resin at the stage of producing the wavelength conversion sheet.

### (Other Additives)

The wavelength conversion material-containing silicone resin composition may contain additives other than the above-described materials as necessary. Specific examples of the additives include a dispersant, a leveling agent, and a defoaming agent.

### [Wavelength Conversion Material-Containing Silicone Resin Composition]

The wavelength conversion material-containing silicone resin composition is obtained by mixing a silicone resin (silicone resin A), a wavelength conversion material, a solvent, and optionally other components (oligomer B, oligomer C, and the like).

The wavelength conversion material-containing silicone resin composition preferably contains the silicone resin A, the oligomer B, and the oligomer C. Here, it is preferable that the silicone resin A contains the oligomer B in an amount smaller than the silicone resin A and the oligomer C in an amount smaller than the silicone A. In the wavelength conversion material-containing silicone resin composition, the mixing ratio of the silicone resin A, the oligomer B and the oligomer C is preferably silicone resin A : oligomer B : oligomer C = 100 : 0.1 to 20 : 0.1 to 20 (mass ratio) since coating properties of the wavelength conversion material-containing silicone resin composition are improved and heat resistance of the cured product (wavelength conversion sheet) of the wavelength conversion material-containing silicone resin composition has more excellent heat resistance.

In the wavelength conversion material-containing silicone resin composition, the mixing ratio of the silicone resin is more preferably silicone resin A : oligomer B : oligomer C = 100 : 0.2 to 15 : 0.2 to 15 (mass ratio), and further preferably silicone resin A : oligomer B : oligomer C = 100 : 1 to 10 : 1 to 10 (mass ratio).

### [Mixing]

First, silicone resins (for example, silicone resin A, oligomer B and oligomer C) are prepared.

The mixing method of the silicone resin A, the oligomer B and the oligomer C is not particularly limited, and any of known methods performed when mixing two or more types of polymers may be used. For example, each of the silicone resin A, the oligomer B, the oligomer C, and optionally other components may be dissolved in an organic solvent, and then the obtained solution may be mixed.

The silicone resin can be more uniformly mixed and stability of the prepared silicone resin composition can be improved. Therefore, it is preferable that the silicone resin is dissolved in a highly volatile and highly soluble organic solvent, and then the organic solvent is replaced with another solvent.

Specifically, first, silicone resin A is added to a highly volatile and highly soluble organic solvent (hereinafter referred to as "solvent P"), then the mixture is heated to a temperature near the boiling point of the solvent P and stirred to dissolve the silicone resin A.

Next, the oligomer B, the oligomer C and optionally other components are added to the obtained solution, and then the oligomer B, the oligomer C and optionally other components are dissolved in the solvent P by the same method as described above.

Next, a solvent having a lower volatility than the solvent P (hereinafter referred to as "solvent Q") is added to the obtained solution, and then the mixture is heated and distilled until the concentration of the solvent P becomes 1% or less, whereby the solvent P can be replaced with the solvent Q. In order to efficiently perform solvent replacement, heating distillation may be performed under reduced pressure.

Residual solvents, water and the like that are contained in each of the silicone resin A, the oligomer B, the oligomer C and other components can be removed by performing solvent replacement. Therefore, stability of the condensed silicone resin composition can be improved by solvent replacement.

Subsequently, the prepared condensed silicone resin composition, the wavelength conversion material, and optionally an additional solvent are mixed to obtain a wavelength conversion material-containing silicone resin composition. Preparation of the wavelength conversion material-containing silicone resin composition can be performed using a known stirring and kneading machine. Examples of the known stirring and kneading machines include a homogenizer, a rotation/revolution stirrer, a three-roller, a ball mill, a planetary ball mill, and a bead mill. After mixing and dispersing or in a mixing and dispersing process, the wavelength conversion material-containing silicone resin composition may be defoamed as necessary under vacuum or reduced pressure conditions.

### [Molding Step S2]

In the molding step S2, a wavelength conversion material-containing silicone resin composition is usually molded into a sheet on a support substrate to obtain a molded body on the support substrate. The support substrate may be peeled off after obtaining the molded body or may not be peeled off. The molding method is not particularly limited as long as it can mold the wavelength conversion material-containing silicone resin composition into a sheet, and can be performed using a known coating apparatus.

Examples of the known coating apparatus include a reverse roll coater, a blade coater, a slit die coater, a direct gravure coater, an offset gravure coater, a reverse roll coater, a blade coater, a kiss coater, a natural roll coater, an air knife coater, a roll blade coater, a variable roll blade coater, a two stream coater, a rod coater, a wire bar coater, an applicator, a dip coater, a curtain coater, a spin coater, and a knife coater. Among them, it is preferable to apply the wavelength conversion material-containing silicone resin composition on the support substrate with a slit die coater or an applicator since the film thickness of the obtained molded body is likely to be uniform.

Examples of other molding methods include printing methods such as screen printing, gravure printing, and lithographic printing. Among them, screen printing is preferable from the viewpoint of workability.

The method of applying the wavelength conversion material-containing silicone resin composition on a support substrate by a screen printing method will be described.

First, the surface of the support substrate is covered with a mask having an opening part of a required pattern, and the wavelength conversion material-containing silicone resin composition is placed in a squeegee part. Next, by moving the squeegee and moving the wavelength conversion material-containing silicone resin composition on the mask with pressurization, the opening part of the mask is filled with the wavelength conversion material-containing silicone resin composition (filling step). Next, after the filling step, the mask is removed.

In this way, a pattern of the wavelength conversion material-containing silicone resin composition can be formed on the support substrate.

Although an example in which the pattern of the wavelength conversion material-containing silicone resin composition is formed on the support substrate has been described, the wavelength conversion material-containing silicone resin composition may be formed on the entire surface of the support substrate.

### [First Heating Step S3]

In the first heating step S3 and the second heating step S4 to be described later, the obtained molded body is heated and cured to obtain a wavelength conversion sheet. Heating of the molded body is usually performed using an instrument such as a natural convection oven, a blast oven, a vacuum oven, an inert oven, a hot plate, a hot press, or an infrared heater. Among them, it is preferable to use a blast oven, from the viewpoint of productivity.

In the first heating step S3, the obtained molded body is cured by allowing it to stand in an atmosphere heated from room temperature (25°C) to 120°C so as to satisfy a requirement of 0.60 ≤ E/D ≤ 0.97.

Here, D represents a mass of the molded body before the first heating step S3.

E represents a mass of the molded body after the first heating step S3.

In the production method of the present embodiment, the first heating step S3 preferably satisfies a requirement of 0.70 ≤ E/D ≤ 0.97, more preferably satisfies a requirement of 0.80 ≤ E/D ≤ 0.96, further preferably satisfies a requirement of 0.85 ≤ E/D ≤ 0.96, and particularly preferably satisfies a requirement of 0.90 ≤ E/D ≤ 0.95.

When the value of E/D is 0.60 or more, it is possible to form a sheet without cracks or wrinkles while securing dispersibility of the wavelength conversion material.

When the value of E/D is 0.97 or less, it becomes possible to reduce components volatilized in the second heating step, and fixation of air bubbles in the sheet can be suppressed.

### [Second Heating Step S4]

In the second heating step S4, the molded body obtained in the first heating step S3 is cured by allowing it to stand in an atmosphere heated from 120°C to 150°C so as to satisfy a requirement of 1.01 ≤ C/B ≤ 1.30. The molded body is heated by using the same instrument as in the first heating step S3.

Here, B represents a content of the T3 unit (the structural unit represented by the formula (A3)) to the total content of all structural units contained in the molded body after the first heating step S3. In other words, B represents the content of T3 silicon atoms to the total content of all silicon atoms contained in the molded body after the first heating step S3.

C represents a content of the T3 unit (the structural unit represented by the formula (A3)) to the total content of all structural units contained in the molded body after the second heating step S4. In other words, C represents the content of T3 silicon atoms to the total content of all silicon atoms contained in the molded body after the second heating step S4.

In the production method of the present embodiment, the second heating step S4 preferably satisfies 1.02 ≤ C/B ≤ 1.20, and more preferably satisfies a requirement of 1.03 ≤ C/B ≤ 1.10.

When the value of C/B is 1.01 or more, the strength of the sheet which can be actually used can be achieved.

When the value of C/B is 1.30 or less, it is possible to obtain a sheet in which fixation of air bubbles, wrinkles and cracks are unlikely to occur.

In this manner, the wavelength conversion sheet of the present embodiment can be obtained.

The first heating step S3 is performed at a temperature where a condensation reaction between the silicone resin (silicone resin A) and the oligomer (oligomer B, oligomer C) does not proceed while reducing the solvent and water contained in the wavelength conversion material-containing silicone resin composition.

The second heating step S4 is performed at a temperature where the condensation reaction between the silicone resin (silicone resin A) and the oligomer (oligomer B, oligomer C) proceeds.

By the first heating step S3 and the second heating step S4, a network structure of the silicone cured product can be appropriately controlled while maintaining dispersibility of a phosphor (wavelength conversion material) in a phosphor solvent (wavelength conversion material-containing silicone resin composition). This makes it possible to suppress wrinkles and cracks, and intrusion of air bubbles in the wavelength conversion sheet to be obtained.

The present inventors presume that mobility of the phosphor (wavelength conversion material) is restricted by reducing the solvent and water in the first heating step S3, and sedimentation of the phosphor can be consequently suppressed. Furthermore, it is presumed that silicone molecules (molecules of the silicone resin) can be densely arranged. By condensing the silicone resin and the oligomer in such a state in the second heating step S4, a wavelength conversion sheet having a storage modulus in an appropriate range can be formed. The wavelength conversion sheet thus obtained hardly breaks, and cracking and discoloration upon use at high temperature are also unlikely to occur.

According to the method for producing the wavelength conversion sheet of the present embodiment, a wavelength conversion sheet excellent in heat resistance can be obtained.

### <Light-Emitting Device>

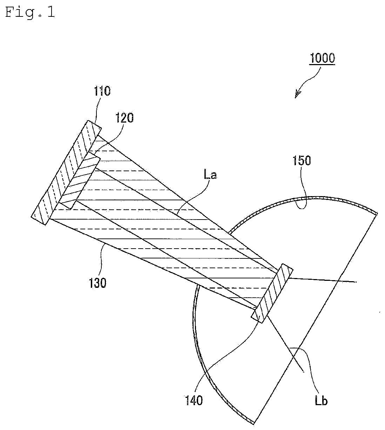

Fig. 1 is a cross-sectional view showing a structure of a light-emitting device including the wavelength conversion sheet of the present embodiment.

The light-emitting device 1000 includes a substrate 110, a semiconductor laser element (light source) 120, a light guide portion 130, a wavelength conversion sheet 140, and a reflecting mirror 150. The wavelength conversion sheet 140 having the above-described configuration can be used.

The semiconductor laser element 120 is set on the substrate 110.

In the light guide portion 130, laser light La emitted from the semiconductor laser element 120 is made incident inside, and the laser light La is guided inside. The semiconductor laser element 120 is optically connected to one end of the light guide portion 130, and the wavelength conversion sheet 140 is optically connected to the other end.
The light guide portion 130 has a pyramidal shape in which the width gradually decreases from one end side to the other end side, and has a configuration in which the laser light La emitted from the semiconductor laser element 120 is focused on the wavelength conversion sheet 140.

The reflecting mirror 150 is a bowl-shaped member disposed around the wavelength conversion sheet 140, and a curved surface facing the wavelength conversion sheet 140 is a light reflecting surface. The reflecting mirror 150 deflects light emitted from the wavelength conversion sheet 140 in front of the device (irradiation direction of the laser light La).

The laser light La irradiated on the wavelength conversion sheet 140 is converted into white light Lb by the wavelength conversion material contained in the wavelength conversion sheet 140 and output from the light-emitting device 1000.

Although the light-emitting device 1000 has one semiconductor laser element 120, it may have two or more.

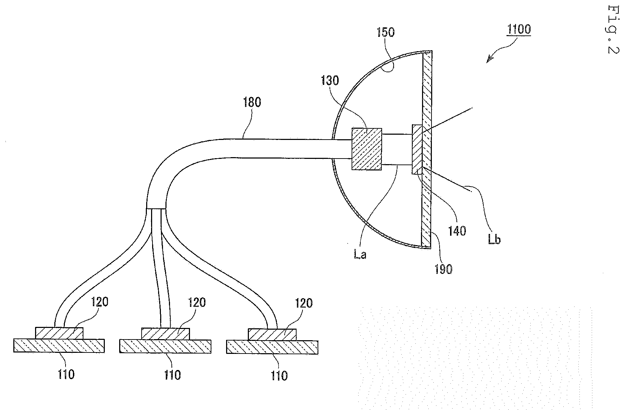

Fig. 2 is a cross-sectional view showing a modified example of the light-emitting device. In Fig. 2 and the following description, the same reference numerals as in Fig. 1 denote the same configurations as those described in Fig. 1.

The light-emitting device 1100 includes a plurality of substrates 110, a plurality of semiconductor laser elements (light sources) 120, a plurality of optical fibers 180, a light guide portion 130, a wavelength conversion sheet 140, a reflecting mirror 150, and a transparent support 190.

In the optical fiber 180, laser light La emitted from the semiconductor laser element 120 is made incident inside, and the laser light La is guided inside. The semiconductor laser element 120 is optically connected to one end of each of the plurality of optical fibers 180. In addition, the plurality of optical fibers 180 are bundled at the other end side, and are optically connected to the light guide portion 130 at the other end in a state of being bundled into one bundle.

In the light guide portion 130, laser light La emitted from the semiconductor laser element 120 is made incident inside, and the laser light La is guided inside and then emitted toward the front of the device. The light guide portion 130 may have a function of converging the laser light La emitted toward the front of the device.

The wavelength conversion sheet 140 is arranged to be opposed to the light guide portion 130 while being separated from the light guide section 130, in a state of being supported by the transparent support 190. The transparent support 190 is provided in front of the device so as to cover an opening portion of the reflecting mirror 150. The transparent support 190 is a member using a transparent material that does not deteriorate due to heat generated during use of the device as a forming material, and for example, a glass plate can be used.

The laser light La irradiated on the wavelength conversion sheet 140 is converted into white light Lb by the wavelength conversion material contained in the wavelength conversion sheet 140 and output from the light-emitting device 1100.

In the light-emitting devices 1000 and 1100, the light source (the semiconductor laser element 120) and the light emitting portion (the wavelength conversion sheet 140) are separated as described above. This facilitates downsizing of the light-emitting device and improvement of designability.

### EXAMPLES

Hereinafter, the present invention will be more specifically described with reference to examples, but the present invention is not limited to the following examples.

### [Gel Permeation Chromatography (GPC) Measurement]

Measurement solutions were prepared by dissolving samples (silicone resin A, oligomer B, oligomer C, silicone resin P and silicone resin Q) in an eluent and then filtering the solution with a membrane filter having a pore size of 0.45 µm. For the obtained prepared solutions, the polystyrene equivalent weight average molecular weight was measured under either of the following conditions.

### <Measurement Conditions 1>

Device name: HLC-8220 GPC manufactured by Tosoh Corporation
Column: TSKgel SuperHM-H × 2 + SuperH2500 × 1 (inner diameter 6.0 mm × 150 mm × 3)
Eluent: toluene
Flow rate: 0.6 mL/min
Detector: RI detector (polarity:-)
Column temperature: 40°C
Injection volume: 40 µL
Molecular weight standard: standard polystyrene

### <Measurement Conditions 2>

Device name: HLC-8120 GPC manufactured by Tosoh Corporation
Column: TSKgel Multipore HXL-M × 3
Eluent: tetrahydrofuran (THF)
Flow rate: 1.0 mL/min
Detection condition: RI detector (polarity: -)
Column temperature: 40°C
Injection volume: 100 µL
Molecular weight standard: standard polystyrene

### [Solution NMR Measurement]

The abundance ratios of the structural units of the silicone resins (silicone resin A, oligomer B, oligomer C and silicone resin P) used in the following examples are values calculated based on the measurement result of either ¹H-NMR method or ²⁹Si-NMR method measured under the following conditions.

### <¹H-NMR Measurement Conditions>

Device name: ECA-500 manufactured by JEOL RESONANCE Inc.
Observation nucleus: ¹H
Observation frequency: 500.16 MHz
Measurement temperature: room temperature
Measurement solvent: DMSO-d₆
Pulse width: 6.60 µsec (45°)
Pulse repetition time: 7.0 sec
Number of integrations: 16
Sample concentration (sample/measurement solvent): 300 mg/0.6 mL

### <²⁹Si-NMR Measurement Conditions>

Device name: 400-MR manufactured by Agilent Technologies
Observation nucleus: ²⁹Si
Observation frequency: 79.42 MHz
Measurement temperature: room temperature
Measurement solvent: CDCl₃
Pulse width: 8.40 µsec (45°)
Pulse repetition time: 15.0 sec
Number of integrations: 4000
Sample concentration (sample/measurement solvent): 300 mg/0.6 mL

### <Preparation of Wavelength Conversion Material-Containing Silicone Resin Composition>

### [Preparation of Condensed Silicone Resin Composition]

### (Synthesis Example 1)

A flask installed in an oil bath was charged with 789.6 g of silicone resin A (polystyrene equivalent weight average molecular weight: 3500, measurement conditions 1), 96.0 g of propyl acetate and 314.40 g of isopropyl alcohol, and the mixture was stirred at 80°C to dissolve the silicone resin A in the solvent.

To the obtained solution were added 8.47 g of oligomer C (polystyrene equivalent weight average molecular weight: < 1000, measurement conditions 1) and 75.08 g of oligomer B (polystyrene equivalent weight average molecular weight: 3400, measurement conditions 1), and the mixture was stirred for 1 hour or more to dissolve the oligomer C and the oligomer B in the solvent.

To the obtained solution were added 274.49 g of 2-butoxyethyl acetate and 0.223 g of 3-glycidoxypropyltrimethoxysilane (silane coupling agent).

The obtained mixture was set in an evaporator, the temperature of the mixture was set at 85°C and the degree of reduced pressure of the evaporator was set at 2.0 kPa. Then, propyl acetate and isopropyl alcohol were distilled off until the total concentration of propyl acetate and isopropyl alcohol in the mixture became 1% by mass or less.

A condensed silicone resin composition of Synthesis Example 1 was thus obtained.

Synthesis Example 1 The structural units contained in the silicone resin A, the structural units contained in the oligomer C, and the structural units contained in the oligomer B that were used are shown in the following table.

The oligomer B contained 95% or more of the resin composed of the repeating units and the abundance ratios shown in Table 3. In addition, in the oligomer B, the sum of areas of the peaks present in a region with a weight average molecular weight of 7500 or more was 20% or more, to the sum of the total areas of the peaks, and the sum of peak areas present in a region with a weight average molecular weight of 1000 or less was 30% or more, to the sum of the total areas of peaks.

### (Silicone Resin A)

**[Table 1]**

| | | | |
|---|---|---|---|
| Structural unit | 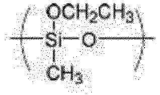 | 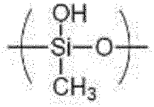 | 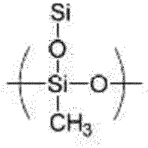 |
| Abundance ratio | 0.03 | 0.23 | 0.74 |

### (Oligomer C)

**[Table 2]**

| | | | |
|---|---|---|---|
| Structural unit | 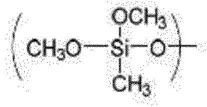 | 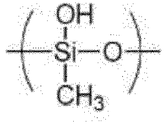 | 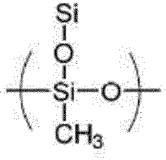 |
| Abundance ratio | 0.39 | 0.49 | 0.12 |

### (Oligomer B)

**[Table 3]**

| | | | | |
|---|---|---|---|---|
| Structural unit | 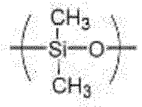 | 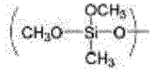 | 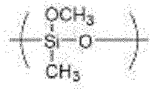 | 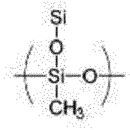 |
| Abundance ratio | 0.20 | 0.10 | 0.45 | 0.25 |

### (Synthesis Example 2)

50 Parts by weight each of commercially available addition type silicone resins SCR-1016A and SCR-1016B (both manufactured by Shin-Etsu Chemical Co., Ltd.) were added and stirred to homogeneity to obtain an addition type silicone resin composition of Synthesis Example 2.

### (Synthesis Example 3)

A flask installed in an oil bath was charged with 40.0 g of silicone resin P (polystyrene equivalent weight average molecular weight: 3500, measurement conditions 1) and 13.3 g of 2-butoxyethyl acetate, and the mixture was stirred at room temperature to dissolve the silicone resin P in the solvent.

To the obtained solution was added 26.6 g of silicone resin Q (polystyrene equivalent weight average molecular weight: 2100, measurement conditions 2), and the mixture was stirred at room temperature to dissolve the silicone resin Q in the solvent.

A condensed silicone resin composition of Synthesis Example 3 was thus obtained. In the condensed silicone resin composition of Synthesis Example 3, the silicone resin P and the silicone resin Q are mixed at a mass ratio of 60 : 40.

Synthetic Example 3 The structural units contained in the silicone resin P and the structural units contained in the silicone resin Q that were used are shown below.

### (Silicone Resin P)

**[Table 4]**

| | | | |
|---|---|---|---|
| Structural unit | 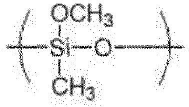 | 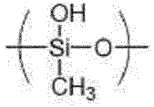 | 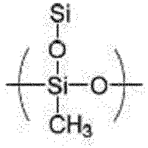 |
| Abundance ratio | 0.08 | 0.15 | 0.77 |

### (Silicone Resin Q)

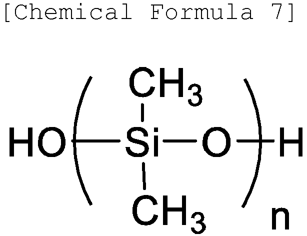

### [Preparation of Wavelength Conversion Material-Containing Silicone Resin Composition]

A wavelength conversion material, a curing catalyst, and silica particles were added to each of the condensed silicone resin compositions prepared in Synthesis Example 1, Synthesis Example 2 and Synthesis Example 3, and sufficiently stirred and mixed to obtain wavelength conversion material-containing silicone resin compositions of Examples 1 to 3 and Comparative Examples 1 and 3. Table 5 shows the blending ratio of the wavelength conversion material-containing silicone resin composition.

As the wavelength conversion material, curing catalyst and silica particles, the following materials were used.
Wavelength conversion material: YAG phosphor (YAG: Ce, particle size: 5.4 µm, 13.6 µm and 17.8 µm) (manufactured by Tokyo Kagaku Kenkyusho Co., Ltd.)
Curing catalyst solution (curing catalyst): a solution containing 15% by mass of phosphoric acid
Silica particles: X-52-7042 (manufactured by Shin-Etsu Chemical Co., Ltd.), average particle diameter of 4 µm

**[Table 5]**

| | Silicone resin | | | YAG phosphor particle size | | | Silica particles Mass ratio | Curing catalyst Solution mass ratio |
|---|---|---|---|---|---|---|---|---|
| | Synthesis Example 1 | Synthesis Example 2 | Synthesis Example 3 | 5.4 µm | 13.6 µm | 17.8 µm | | |
| Example 1 | 50 | - | - | - | - | 50 | 1 | 1 |
| Example 2 | 40 | - | - | - | - | 60 | 1 | 0.8 |
| Example 3 | 70 | - | - | - | - | 30 | 0 | 1.4 |
| Comparative Example 1 | - | 50 | - | - | 50 | - | - | - |
| Comparative Example 3 | - | - | 63 | 37 | - | - | 0 | 1.3 |

### <Preparation of Wavelength Conversion Sheet>

Each of the wavelength conversion material-containing silicone resin compositions of Examples 1 to 3 and Comparative Examples 1 and 3 was added to an aluminum cup with a diameter of 4 cm to prepare molded bodies.

### [Examples 1 to 3 and Comparative Examples 1 and 3]

The molded bodies of Examples 1 to 3 and Comparative Examples 1 and 3 were cured by raising the temperature from room temperature (25°C) to 120°C at a rate of 4°C/min in an oven (first heating step). Thereafter, the temperature was raised from 120°C to 150°C at a rate of 7°C/min and allowed to stand at 150°C for 5 hours for further curing (second heating step). In this way, wavelength conversion sheets with a diameter of 4 cm and a thickness of 1 mm were obtained.

The value of E/D in the first heating step of Example 1 is shown in Table 6. The value of E/D in the first heating step of Example 1 was 0.93.

### [Comparative Example 2]

When the molded body of Example 1 was cured by placing in an oven preheated to 160°C and allowing to stand at 160°C for 5 hours, numerous air bubbles were confirmed.

The value of E/D in the first heating step of Comparative Example 2 is shown in Table 6. The value of E/D in the first heating step of Comparative Example 2 was 1.00.

### [Calculation of T3 Form Amounts B and C Using Solid State ²⁹Si-NMR]

For the wavelength conversion sheet of Example 1, solid state ²⁹Si-NMR was measured under the following measurement conditions, and values of B and C that are the content of T3 silicon atoms (hereinafter referred to as "T3 unit amount") to the total content of all silicon atoms contained in the wavelength conversion sheet of Example 1 were calculated. C/B calculated using the calculated B and C is shown as "T3 unit amount ratio" in Table 6.

### (Measurement Conditions)

Device name: AVANCE300 manufactured by Bruker
Observation nucleus: ²⁹Si
Observation frequency: 59.6 MHz
Measurement temperature: room temperature
Measurement method: DDMAS method
Reference material: hexamethylcyclotrisiloxane (Set to -9.66 ppm, equivalent to TMS 0 ppm setting)
MAS condition: 3.5 kHz
Pulse width: π/6 (1.4 µsec)
Latency: 20.0 sec
Number of integrations: 4096
Sample amount: 290 mg

The value of C/B in the second heating step of Example 1 is shown in Table 6. The value of C/B in the first heating step of Example 1 was 1.05.

The T3 unit amount (C) in the wavelength conversion sheet of Example 1 was 80% to the total content of all structural units contained in the wavelength conversion sheet.

**[Table 6]**

| | T3 unit amount ratio | Mass ratio |
|---|---|---|
| | C/B | E/D |
| Example 1 | 1.05 | 0.93 |
| Comparative Example 2 | - | 1.00 |

### <Evaluation>

### [Measurement of Storage Elastic Modulus]

For the wavelength conversion sheets obtained in Examples 1 to 3 and Comparative Examples 1 and 3, storage elastic moduli at room temperature (25°C) and 150°C were each measured under the following conditions. As a sample piece, one with a thickness of 1 mm, a length of 20 mm and a width of 5 mm was used.

### (Measurement Conditions)

Measuring apparatus: viscoelasticity measuring apparatus DMA Q-800 (manufactured by TA Instruments)
Strain: 0.1%
Angular frequency: 10 Hz
Temperature range: 25°C to 150°C
Temperature rise rate: 5°C/min
Measurement atmosphere: in atmosphere

The values of the storage elastic moduli at 25°C and 150°C of the wavelength conversion sheets obtained in Examples 1 to 3 and Comparative Examples 1 and 3 are shown in Table 7.

### [Measurement of Shore D Hardness]

For the wavelength conversion sheets obtained in Examples 1 to 3 and Comparative Examples 1 and 3, the Shore D hardness was measured under the following conditions.

As a measuring apparatus, an automatic low pressure loader for durometer (rubber · plastic hardness tester) GS-610 manufactured by TECLOCK Corporation equipped with a durometer GS-720G (type D) was used. Using this apparatus, the Shore D hardness was measured for the wavelength conversion sheets obtained in Examples 1 to 3 and Comparative Examples 1 and 3 at a descending speed of 1 mm/sec. The measurement was performed at 5 positions, and the average value was calculated.

The Shore D hardness values of the wavelength conversion sheets obtained in Examples 1 to 3 and Comparative Examples 1 and 3 are shown in Table 7.

### [Evaluation of Heat Resistance]

The wavelength conversion sheets obtained in Examples 1 to 3 and Comparative Examples 1 and 3 were allowed to stand in an oven at 250°C for 24 hours and then returned to room temperature. For the wavelength conversion sheets after heating, the presence or absence of wrinkles, cracks and coloration was visually confirmed.

For the wavelength conversion sheets obtained in Examples 1 to 3 and Comparative Examples 1 and 3, evaluation results of heat resistance by visual observation are shown in Table 7.

In all of the wavelength conversion sheets obtained in Examples 1 to 3 and Comparative Examples 1 and 3, wrinkles and cracks were not confirmed in the wavelength conversion sheet after heating.

**[Table 7]**

| | Storage elastic modulus (Gpa) | | Shore D hardness | Evaluation of heat resistance |
|---|---|---|---|---|
| | 25°C | 150°C | | Appearance |
| Example 1 | 3.8 | 1.1 | 77 | Good |
| Example 2 | 5.9 | 1 | 76 | Good |
| Example 3 | 2.6 | 0.6 | 66 | Good |
| Comparative Example 1 | 3.7 | 0.01 | 26 | Coloration |
| Comparative Example 3 | 0.05 | 0.005 | 58 | Largely deformed |

Also, for the wavelength conversion sheets obtained in Examples 1 to 3 and Comparative Example 1, change in hue was confirmed by measurement with a color difference meter. The change in hue was confirmed under the following conditions.

### (Measurement Conditions)

Measuring apparatus: color difference meter "CM-3600d" (manufactured by KONICA MINOLTA, INC.)
Measurement diameter: 4 mm
Measurement mode: SCE + SCI
Light source: D65
Color difference formula: CIE1994

Moreover, the measurement results of the color difference meter for the wavelength conversion sheets obtained in Examples 1 to 3 and Comparative Example 1 are shown in Table 8.

**[Table 8]**

| | Color difference meter measurement (D65) | | | | | | | | |
|---|---|---|---|---|---|---|---|---|---|
| | Before heat resistance test | | | After heat resistance test | | | Difference between before and after test | | |
| | L* | a* | b* | L* | a* | b* | ΔL* | Δa* | Δb* |
| Example 1 | 96.85 | -1.48 | 101.5 | 102.5 | -0.17 | 105.9 | 5.65 | 1.31 | 4.4 |
| Example 2 | 98.6 | 0.52 | 106.6 | 101.4 | -0.02 | 105.7 | 2.8 | -0.54 | -0.9 |
| Example 3 | 92.6 | -2.37 | 97.4 | 98.0 | -3.42 | 99.6 | 5.4 | -1.05 | 2.2 |
| Comparative Example 1 | 96.0 | 1.86 | 103.3 | 31.1 | 5.43 | 9.04 | -64.9 | 3.57 | -94.26 |

As shown in Table 7, the wavelength conversion sheets obtained in Examples 1 to 3 had a storage modulus at 25°C in the range of 2 GPa or more and 10 GPa or less, and a storage modulus at 150°C in the range of 0.1 GPa or more and 5 GPa or less. In addition, the wavelength conversion sheets obtained in Examples 1 to 3 had a Shore D hardness of 50 or more. In the wavelength conversion sheets obtained in Examples 1 to 3, no wrinkles, cracks and coloration were confirmed even after heating in an oven at 250°C for 24 hours, and the heat resistance was excellent.

On the other hand, as shown in Table 7, the wavelength conversion sheet obtained in Comparative Example 1 had a storage modulus at 25°C in the range of 2 GPa or more and 10 GPa or less, but had a storage modulus at 150°C of less than 0.1 GPa. Further, the wavelength conversion sheet obtained in Comparative Example 1 had a Shore D hardness of less than 50. In the wavelength conversion sheet obtained in Comparative Example 1, coloration was confirmed after heating in an oven at 250°C for 24 hours, and the heat resistance was inferior.

Also, as shown in Table 7, the wavelength conversion sheet obtained in Comparative Example 3 had a storage modulus at 25°C of less than 2 GPa and a storage modulus at 150°C of less than 0.1 GPa. In the wavelength conversion sheet obtained in Comparative Example 3, large shape deformation was confirmed after heating in an oven at 250°C for 1 hour, and the heat resistance was inferior.

In the examples, a product having an absolute value of ΔL* of 10 or less and absolute values of Δa* and Δb* of 5 or less was determined as a good product.

As shown in Table 8, the absolute values of ΔL*, Δa* and Δb* of the wavelength conversion sheets obtained in Examples 1 to 3 were smaller than those of the wavelength conversion sheet obtained in Comparative Example 1. Based on this, it was revealed that the wavelength conversion sheets obtained in Examples 1 to 3 were superior in heat resistance as compared with the wavelength conversion sheet obtained in Comparative Example 1.

Based on the above results, it was confirmed that the wavelength conversion sheet of the present invention is useful.

### INDUSTRIAL APPLICABILITY

According to the present invention, it is possible to provide a wavelength conversion sheet excellent in heat resistance, a laminate and light-emitting device including the wavelength conversion sheet, and a method for producing a wavelength conversion sheet.

### DESCRIPTION OF REFERENCE SIGNS

- 1000, 1100...: Light-emitting device
- 110...: Substrate
- 120...: Semiconductor laser element (light source)
- 130...: Light guide portion
- 140...: Wavelength conversion sheet
- 150...: Reflecting mirror
- 180...: Optical fiber
- 190...: Transparent support
- La...: Laser light
- Lb...: White light

## Claims

1. A wavelength conversion sheet comprising a condensed silicone resin cured product and a wavelength conversion material, the wavelength conversion sheet having a storage modulus at 25°C of 2 GPa or more and 10 GPa or less and a storage modulus at 150°C of 0.1 GPa or more and 5 GPa or less.

2. The wavelength conversion sheet according to claim 1, wherein the content of the condensed silicone resin cured product is 5% by mass or more and 80% by mass or less to the total content of the condensed silicone resin cured product and the wavelength conversion material.

3. The wavelength conversion sheet according to claim 1 or 2, wherein the thickness is 10 µm or more and 1 mm or less.

4. The wavelength conversion sheet according to any one of claims 1 to 3, wherein the condensed silicone resin cured product comprises a structural unit represented by the following formula (A3), 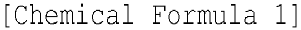 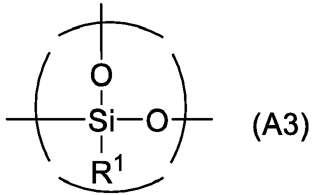 wherein R¹ represents an alkyl group having 1 to 10 carbon atoms or an aryl group having 6 to 10 carbon atoms.

5. The wavelength conversion sheet according to claim 4, wherein the condensed silicone resin cured product may further comprise one or more structural units selected from the group consisting of a structural unit represented by the following formula (A1), a structural unit represented by the following formula (A1') and a structural unit represented by the following formula (A2), and
the total content of the structural unit represented by the formula (A3), the structural unit represented by the following formula (A1), the structural unit represented by the following formula (A1') and the structural unit represented by the following formula (A2) contained in the condensed silicone resin cured product is 50% by mole or more to the total content of all structural units contained in the condensed silicone resin cured product, 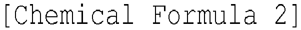 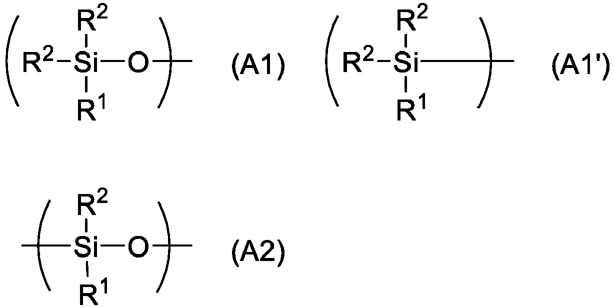 in the formulas (A1), (A1') and (A2),
R¹ represents an alkyl group having 1 to 10 carbon atoms or an aryl group having 6 to 10 carbon atoms;
R² represents an alkoxy group having 1 to 4 carbon atoms or a hydroxyl group; and
a plurality of R¹s and R²s each may be the same or different.

6. The wavelength conversion sheet according to claim 4 or 5, wherein the content of the structural unit represented by the formula (A3) contained in the condensed silicone resin cured product is 50% by mole or more to the total content of all structural units contained in the condensed silicone resin cured product.

7. The wavelength conversion sheet according to claim 5 or 6, wherein the R¹s are a methyl group, and the R²s are an alkoxy group having 1 to 3 carbon atoms or a hydroxyl group.

8. The wavelength conversion sheet according to any one of claims 1 to 7, wherein the Shore D hardness is 50 or more.

9. A laminate comprising a wavelength conversion sheet as defined in any one of claims 1 to 8; and
a substrate provided on one surface of the wavelength conversion sheet.

10. A light-emitting device comprising the wavelength conversion sheet as defined in any one of claims 1 to 8 or the laminate as defined in claim 9.

11. A method for producing the wavelength conversion sheet as defined in any one of claims 4 to 8, comprising:
a preparation step of preparing a wavelength conversion material-containing silicone resin composition comprising a condensed silicone resin, a wavelength conversion material, and a solvent;
a molding step of molding a wavelength conversion material-containing silicone resin composition into a sheet to obtain a molded body;
a first heating step of curing the molded body by allowing it to stand in an atmosphere heated from room temperature to 120°C so as to satisfy a requirement of 0.60 ≤ E/D ≤ 0.97; and
a second heating step of curing the molded body after the first heating step by allowing it to stand in an atmosphere heated from 120°C to 150°C so as to satisfy a requirement of 1.01 ≤ C/B ≤ 1.30,
wherein,
D represents a mass of the molded body before the first heating step;
E represents a mass of the molded body after the first heating step;
B represents a content of the structural unit represented by the formula (A3) to the total content of all structural units contained in the molded body after the first heating step; and
C represents a content of the structural unit represented by the formula (A3) to the total content of all structural units contained in the molded body after the second heating step.
